(19)

Europäisches Patentamt
European Patent Office
Office européen des brevets

(11) **EP 4 521 658 A1**

(12) **EUROPEAN PATENT APPLICATION**
published in accordance with Art. 153(4) EPC

(43) Date of publication:
**12.03.2025 Bulletin 2025/11**

(21) Application number: **23810754.4**

(22) Date of filing: **27.04.2023**

(51) International Patent Classification (IPC):
*H04B 10/291* (2013.01)

(52) Cooperative Patent Classification (CPC):
**H04B 10/291; H04B 10/50**

(86) International application number:
**PCT/CN2023/091372**

(87) International publication number:
**WO 2023/226681 (30.11.2023 Gazette 2023/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.05.2022 CN 202210577560**

(71) Applicant: **Huawei Technologies Co., Ltd.**
**Shenzhen, Guangdong 518129 (CN)**

(72) Inventors:
• **JI, Chunhui**
  **Shenzhen, Guangdong 518129 (CN)**
• **HAN, Dong**
  **Shenzhen, Guangdong 518129 (CN)**
• **WANG, Tianxiang**
  **Shenzhen, Guangdong 518129 (CN)**
• **LI, Xu**
  **Shenzhen, Guangdong 518129 (CN)**
• **ZHANG, Weiwei**
  **Shenzhen, Guangdong 518129 (CN)**

(74) Representative: **Gill Jennings & Every LLP**
**The Broadgate Tower**
**20 Primrose Street**
**London EC2A 2ES (GB)**

(54) **PHOTOELECTRIC AMPLIFICATION CIRCUIT AND SIGNAL PROCESSING METHOD**

(57) This application provides a photoelectric amplification circuit and a signal processing method. The photoelectric amplification circuit includes a first photodiode and a second photodiode that are connected in parallel. A Doherty circuit structure is used, so that power supply efficiency of the photodiode in a back-off state can be improved. In addition, an impedance modulation unit is used, to implement dynamic load conversion from a back-off point to a maximum output point. This helps maintain high output efficiency of the first photodiode and the second photodiode in an interval between the maximum power point and the back-off point.

FIG. 4

EP 4 521 658 A1

## Description

This application claims priority to Chinese Patent Application No. 202210577560.8, filed with the China National Intellectual Property Administration on May 25, 2022 and entitled "PHOTOELECTRIC AMPLIFICATION CIRCUIT AND SIGNAL PROCESSING METHOD", which is incorporated herein by reference in its entirety.

## TECHNICAL FIELD

This application relates to the field of communication technologies, and in particular, to a photoelectric amplification circuit and a signal processing method.

## BACKGROUND

A radio frequency photonic base station is a wireless communication system that solves a performance bottleneck of a pure electric system by using a photoelectric convergence technology, to implement ultra-wideband, miniaturization, and low power consumption. For example, an architecture of the radio frequency photonic base station may include a new radio frequency photonic front end formed by a high-power photodiode (photodiode, PD) and optical amplifier. In this way, a radio frequency signal may be amplified in optical domain, and a power amplifier (power amplifier, PA) may be replaced with a high-power PD with ultra-high bandwidth to directly meet a requirement of a back-end antenna for radiating a microwave signal. To maximize spectral efficiency and increase a system capacity, an orthogonal frequency division multiplexing (orthogonal frequency division multiplexing, OFDM) technology is generally used in a current communication system (for example, a 4th generation (4th generation, 4G) communication system and a 5th generation (5th generation, 5G) communication system) as a standard solution for downlink communication signal modulation. In OFDM, subcarriers are orthogonal to each other in time domain, and overlap with each other in a spectrum. Therefore, the OFDM has high spectrum utilization, and has great advantages in aspects such as anti-multipath fading and low implementation complexity. However, a main disadvantage of the OFDM is that the OFDM has a high peak-to-average ratio, and therefore has a stricter requirement on a linear dynamic range of a radio frequency transmit path. Therefore, how to improve back-off efficiency of the new radio frequency photonic front end formed by the high-power PD and the optical amplifier while meeting the linear dynamic range becomes a problem to be resolved.

## SUMMARY

This application provides a photoelectric amplification circuit and a signal processing method. In the photoelectric amplification circuit, a Doherty circuit structure based on a high-power PD is used, so that power supply efficiency of the high-power PD in a back-off state can be improved, and an ultra-wideband feature can be considered, to help flexibly deploy all services in a full frequency band of a base station and reduce costs.

According to a first aspect, this application provides a photoelectric amplification circuit. The photoelectric amplification circuit includes a first photodiode, a second photodiode, and an impedance modulation unit. The first photodiode includes a first input end and a first output end. The first input end is configured to receive a first optical signal, and the first output end is configured to output a first radio frequency signal. The second photodiode includes a second input end and a second output end. The second input end is configured to receive a second optical signal, and the second output end is configured to output a second radio frequency signal. The first optical signal and the second optical signal are two optical signals obtained by processing an input radio frequency signal. The impedance modulation unit is connected to the first photodiode, and is connected to the second photodiode. When power of a radio frequency signal modulated to the first optical signal is greater than or equal to preset back-off point power, the impedance modulation unit is configured to: modulate an impedance of the first output end to a first impedance and modulate an impedance of the second output end to the first impedance based on power of the first optical signal and power of the second optical signal. The first impedance is a corresponding impedance when output power of the first photodiode and output power of the second photodiode are maximum.

In the photoelectric amplification circuit, the first photodiode and the second photodiode are in a parallel connection relationship. A Doherty circuit structure is used, so that power supply efficiency of the photodiode in a back-off state can be improved. In addition, the impedance modulation unit is used, to implement dynamic load conversion from a back-off point to a maximum output point. This helps maintain high output efficiency of the first photodiode and the second photodiode in an interval between the maximum power point and the back-off point.

In a possible implementation, the preset back-off point power is power of the input radio frequency signal when the first radio frequency signal and the second radio frequency signal that are output by the first photodiode and the second photodiode meet preset signal quality. The preset back-off point power is determined based on saturation power and a power back-off value.

In a possible implementation, the saturation power is power of the input radio frequency signal when the output power of the first photodiode and the output power of the second photodiode are maximum. The power back-off value is determined based on a peak-to-average ratio of the input radio frequency signal and the preset signal quality.

In a possible implementation, the preset back-off point power is further determined based on a modulation scheme of the input radio frequency signal. The modulation scheme of the input radio frequency signal includes quadrature amplitude modulation and/or phase-shift keying modulation.

In a possible implementation, when the power of the radio frequency signal modulated to the first optical signal is less than or equal to the preset back-off point power, the impedance modulation unit is configured to modulate the impedance of the first output end to a second impedance based on the power of the first optical signal, where the second impedance is greater than or equal to the first impedance.

In the photoelectric amplification circuit, when the power of the radio frequency signal modulated to the first optical signal is low, the first photodiode may work in a non-saturated state by adjusting an impedance of the photodiode at an output end, and present a high impedance at the output end. In this case, the first photodiode may also achieve high working efficiency.

In a possible implementation, the photoelectric amplification circuit further includes an electro-optical conversion unit. The electro-optical conversion unit is connected to the first input end, and is connected to the second input end. The electro-optical conversion unit is configured to process the input radio frequency signal to obtain the first optical signal and the second optical signal. For example, processing such as electro-optical conversion or amplification is performed on the input radio frequency signal, so that the radio frequency signal is converted into an amplified optical signal.

In a possible implementation, when the power of the radio frequency signal modulated to the first optical signal is less than or equal to the preset back-off point power, the electro-optical conversion unit is further configured to control the power of the second optical signal to be 0.

In the photoelectric amplification circuit, when the power of the radio frequency signal modulated to the first optical signal is low, the power of the second optical signal may be controlled, so that the second photodiode does not work, and the first photodiode works in the non-saturated state. In this case, the first photodiode and the second photodiode work in different states.

In a possible implementation, when the power of the radio frequency signal modulated to the first optical signal is greater than or equal to the preset back-off point power, the electro-optical conversion unit is further configured to increase the power of the second optical signal.

In the photoelectric amplification circuit, when the power of the radio frequency signal modulated to the first optical signal is high, the power of the second optical signal may be increased, so that the second photodiode may also achieve high working efficiency.

In a possible implementation, the electro-optical conversion unit includes an electrical power splitter, a first laser, a second laser, a first optical amplifier, and a second optical amplifier. The electrical power splitter is connected to the first laser, and is connected to the second laser. The electrical power splitter is configured to split the input radio frequency signal into a first input radio frequency signal and a second input radio frequency signal based on a preset proportion. The first laser is configured to: receive the first input radio frequency signal, and convert the first input radio frequency signal into a first input optical signal. The second laser is configured to: receive the second input radio frequency signal, and convert the second input radio frequency signal into a second input optical signal. The first laser is connected to the first optical amplifier, and the first optical amplifier is connected to the first input end. The second laser is connected to the second optical amplifier, and the second optical amplifier is connected to the second input end. The first optical amplifier is configured to: amplify the first input optical signal to obtain the first optical signal, and output the first optical signal. The second optical amplifier is configured to: amplify the second input optical signal to obtain the second optical signal, and output the second optical signal.

In the photoelectric amplification circuit, the input radio frequency signal may be split into two radio frequency signals by using the electrical power splitter, then the two radio frequency signals are converted into two optical signals by using two lasers respectively, and finally the two optical signals are amplified by using two optical amplifiers respectively, so that the radio frequency signal is converted into amplified optical signals.

In a possible implementation, the electro-optical conversion unit includes an electrical power splitter, a first laser, a second laser, an optical multiplexer, an optical amplifier, and an optical demultiplexer. The electrical power splitter is connected to a first laser, and is connected to the second laser. The electrical power splitter is configured to split the input radio frequency signal into a first input radio frequency signal and a second input radio frequency signal based on a preset proportion. The first laser is configured to: receive the first input radio frequency signal, and convert the first input radio frequency signal into a first input optical signal. The second laser is configured to: receive the second input radio frequency signal, and convert the second input radio frequency signal into a second input optical signal. The optical multiplexer is connected to the first laser, and is connected to the second laser. The optical multiplexer is configured to multiplex the first input optical signal and the second input optical signal to a same channel. The optical multiplexer is connected to the optical amplifier, and the optical amplifier is connected to the optical demultiplexer. The optical amplifier is configured to amplify the first input optical signal and the second input optical signal to obtain the first optical signal and the second optical signal. The optical demultiplexer is configured to demultiplex the first optical signal and the second optical signal that are in the same channel to two different channels. The optical demultiplexer is connected to the first input end, and is connected to the second input end.

In the photoelectric amplification circuit, the input radio frequency signal may be split into two radio frequency signals by using the electrical power splitter, then the two radio frequency signals are converted into two optical signals by using two lasers respectively, and finally two amplified optical signals are obtained by using an optical amplifier, an optical multiplexer, and an optical demultiplexer, so that the radio frequency signal is converted into amplified optical signals. In addition, one optical amplifier is used. This reduces usage of active devices and helps reduce power consumption of the photoelectric amplification circuit.

In a possible implementation, the first laser and the second laser are directly modulated electro-optical modulators.

In a possible implementation, the first laser and the second laser are externally modulated electro-optical modulators. The electro-optical conversion unit further includes a first laser source and a second laser source. The first laser source is connected to the first laser, and is configured to provide laser light for the first laser, to enable the first laser to convert the first input radio frequency signal into the first input optical signal. The second laser source is connected to the second laser, and is configured to provide laser light for the second laser, to enable the second laser to convert the second input radio frequency signal into the second input optical signal.

In the photoelectric amplification circuit, because the externally modulated electro-optical modulator needs to work normally only by using an external laser source, the photoelectric amplification circuit further includes two laser sources. The two laser sources are respectively connected to two externally modulated electro-optical modulators, so that the externally modulated electro-optical modulator can convert a radio frequency signal into an optical signal.

In a possible implementation, the electro-optical conversion unit further includes a laser source and an optical power splitter. The laser source is connected to the optical power splitter, and the optical power splitter is connected to the first laser and the second laser. The laser source and the optical power splitter are configured to provide laser sources for the first laser and the second laser, to enable the first laser to convert the first input radio frequency signal into the first input optical signal, and enable the second laser to convert the second input radio frequency signal into the second input optical signal.

In the photoelectric amplification circuit, because the externally modulated electro-optical modulator needs to work normally only by using an external laser source, the photoelectric amplification circuit further includes a laser source and an optical power splitter. In this case, laser sources can be respectively provided for two externally modulated electro-optical modulators, so that the externally modulated electro-optical modulator can convert a radio frequency signal into an optical signal.

In a possible implementation, the electro-optical conversion unit includes a laser, an optical splitter, an optical power controller, a first optical amplifier, and a second optical amplifier. The laser is connected to the optical splitter. The laser is configured to: receive the input radio frequency signal, and convert the input radio frequency signal into an optical signal. The optical splitter is configured to split the optical signal into a first input optical signal and a second input optical signal. The optical splitter is connected to the first optical amplifier, and the first optical amplifier is connected to the first input end. The first optical amplifier is configured to: amplify the first input optical signal to obtain the first optical signal, and output the first optical signal. The optical splitter is connected to the optical power controller, the optical power controller is connected to the second optical amplifier, and the second optical amplifier is connected to the second input end. The optical power controller is configured to control the second input optical signal, to enable power of the second input optical signal to be different from power of the first input optical signal. The second optical amplifier is configured to: amplify the second input optical signal to obtain the second optical signal, and output the second optical signal.

In the photoelectric amplification circuit, by using the optical power controller, average optical power of two optical signals output by the optical splitter may be enabled to be different, so that average optical power of the first optical signal and the second optical signal that are output by the first optical amplifier and the second optical amplifier is different, to enable the first photodiode and the second photodiode to work in different states.

In a possible implementation, the electro-optical conversion unit includes a laser, an optical splitter, an optical power controller, an optical multiplexer, an optical amplifier, and an optical demultiplexer. The laser is connected to the optical splitter. The laser is configured to: receive the input radio frequency signal, and convert the input radio frequency signal into an optical signal. The optical splitter is configured to split the optical signal into a first input optical signal and a second input optical signal. The optical splitter is connected to the optical power controller, and is connected to the optical multiplexer. The optical power controller is connected to the optical multiplexer. The optical power controller is configured to control the second input optical signal, to enable power of the second input optical signal to be different from power of the first input optical signal. The optical multiplexer is configured to multiplex the first input optical signal and the second input optical signal to a same channel. The optical multiplexer is connected to the optical amplifier, and the optical amplifier is connected to the optical demultiplexer. The optical amplifier is configured to amplify the first input optical signal and the second input optical signal to obtain the first optical signal and the second optical signal. The optical demultiplexer is configured to demultiplex the first optical signal and the second optical signal that are in the same channel to two different channels. The optical demultiplexer is connected to the first input end, and is connected to the second input end.

In a possible implementation, the laser is a directly modulated laser, or the laser is an externally modulated electro-optical modulator. When the laser is the externally modulated electro-optical modulator, the electro-optical conversion unit further includes a laser source. The laser source is connected to the laser, and is configured to provide a laser source for the laser, to enable the laser to convert the input radio frequency signal into an optical signal.

In a possible implementation, the electro-optical conversion unit further includes a first optical delayer and a second optical delayer. The first optical amplifier is connected to the first optical delayer, and the second optical amplifier is connected to the second optical delayer; or the optical demultiplexer is connected to the first optical delayer, and is connected to the second optical delayer. The first optical delayer is connected to the first input end, the second optical delayer is connected to the second input end, and the first optical delayer and the second optical delayer are configured to align a phase of the first optical signal with a phase of the second optical signal.

The electro-optical conversion circuit may further include an optical delayer, so that the phase of the first optical signal and the phase of the second optical signal are aligned. This helps keep phases of output signals of the first photodiode and the second photodiode consistent at a combination point.

In a possible implementation, the photoelectric amplification circuit further includes a first matching network and a second matching network. The first matching network is connected to the first output end, and is configured to implement impedance matching between the first output end and the circuit. The second matching network is connected to the second output end, and is configured to implement impedance matching between the second output end and the circuit.

The electro-optical conversion circuit may further include a matching network, so that output ports of the first photodiode and the second photodiode may match an impedance of a subsequent circuit.

In a possible implementation, the photoelectric amplification circuit further includes a first electrical phase compensation line and a second electrical phase compensation line. The first electrical phase compensation line is connected to the impedance modulation unit, and is configured to adjust a phase of the first radio frequency signal. The second electrical phase compensation line is connected to the impedance modulation unit, and is configured to adjust a phase of the second radio frequency signal. The phase of the first radio frequency signal is the same as the phase of the second radio frequency signal.

The electro-optical conversion circuit may further include an electrical phase compensation line. This helps keep the phases of the output signals of the first photodiode and the second photodiode consistent at the combination point.

According to a second aspect, this application provides a signal processing method. The signal processing method may be executed by a radio frequency signal amplification apparatus. The radio frequency signal amplification apparatus may obtain power of a first optical signal and power of a second optical signal. The first optical signal and the second optical signal are two optical signals obtained by processing an input radio frequency signal. When power of a radio frequency signal modulated to the first optical signal is greater than or equal to preset back-off point power, an impedance of a first output end of a first photodiode is modulated to a first impedance and an impedance of a second output end of a second photodiode is modulated to the first impedance based on the power of the first optical signal and the power of the second optical signal. The first impedance is a corresponding impedance when output power of the first photodiode and output power of the second photodiode are maximum.

In the method, the impedance of the first photodiode and the impedance of the second photodiode are adjusted to implement dynamic load conversion from a back-off point to a maximum output point. This helps maintain high output efficiency of the first photodiode and the second photodiode in an interval between the maximum power point and the back-off point.

In a possible implementation, the preset back-off point power is power of the input radio frequency signal when a first radio frequency signal and a second radio frequency signal that are output by the first photodiode and the second photodiode meet preset signal quality. The preset back-off point power is determined based on saturation power and a power back-off value.

In a possible implementation, the saturation power is power of the input radio frequency signal when the output power of the first photodiode and the output power of the second photodiode are maximum. The power back-off value is determined based on a peak-to-average ratio of the input radio frequency signal and the preset signal quality.

In a possible implementation, the preset back-off point power is further determined based on a modulation scheme of the input radio frequency signal. The modulation scheme of the input radio frequency signal includes quadrature amplitude modulation and/or phase-shift keying modulation.

In a possible implementation, when the power of the radio frequency signal modulated to the first optical signal is less than or equal to the preset back-off point power, the impedance of the first output end is modulated to a second impedance based on the power of the first optical signal, where the second impedance is greater than or equal to the first impedance.

In a possible implementation, when the power of the radio frequency signal modulated to the first optical signal is less than or equal to the preset back-off point power, the power of the second optical signal is controlled to be 0; or

when the power of the radio frequency signal modulated to the first optical signal is greater than or equal to the preset back-off point power, the power of the second optical signal is increased.

According to a third aspect, this application provides an apparatus. The apparatus may include the photoelectric amplification circuit described in the first aspect. In a possible implementation, the apparatus may include a one-to-one corresponding module for performing the method/operation/step/action described in the second aspect or the possible implementations of the second aspect. The module may be implemented by a hardware circuit, software, or a hardware circuit in combination with software. In a possible implementation, the apparatus may include a transceiver unit and a processing unit.

For specific descriptions of the method/operation/step/action performed by the apparatus, refer to corresponding descriptions in the second aspect and the possible implementations of the second aspect. Details are not described herein again. It may be understood that the apparatus may also implement effect that can be implemented in the second aspect.

According to a fourth aspect, this application provides a device, including a processor. The processor is coupled to a memory, the memory is configured to store instructions, and when the instructions are executed by the processor, the apparatus is enabled to implement the method in the second aspect and the possible implementations of the second aspect.

According to a fifth aspect, an embodiment of this application further provides a computer-readable storage medium. The computer-readable storage medium stores instructions, and when the instructions are run on a computer, the computer is enabled to perform the method in the second aspect and the possible implementations of the second aspect.

According to a sixth aspect, an embodiment of this application provides a chip system. The chip system includes a processor, and may further include a memory, configured to implement the functions in the second aspect and the possible implementations of the second aspect. The chip system may include a chip, or may include a chip and another discrete component.

According to a seventh aspect, an embodiment of this application further provides a computer program product, including instructions. When the instructions are run on a computer, the computer is enabled to perform the method in the second aspect and the possible implementations of the second aspect.

**BRIEF DESCRIPTION OF DRAWINGS**

FIG. 1 is a diagram of a radio frequency signal amplification apparatus in a base station system according to this application;

FIG. 2 is a diagram of a relationship between power and output efficiency of an input radio frequency signal according to this application;

FIG. 3 is a diagram of a photoelectric amplification circuit according to this application;

FIG. 4 is a diagram of a photoelectric amplification circuit including an electro-optical conversion unit according to this application;

FIG. 5 is a diagram of a first photoelectric amplification circuit including an electro-optical conversion unit according to this application;

FIG. 6 is a diagram of a second photoelectric amplification circuit including an electro-optical conversion unit according to this application;

FIG. 7 is a diagram of a third photoelectric amplification circuit including an electro-optical conversion unit according to this application;

FIG. 8 is a diagram of a fourth photoelectric amplification circuit including an electro-optical conversion unit according to this application;

FIG. 9a is a diagram of a fifth photoelectric amplification circuit including an electro-optical conversion unit according to this application;

FIG. 9b is a diagram of a sixth photoelectric amplification circuit including an electro-optical conversion unit according to this application;

FIG. 10a is a diagram of a seventh photoelectric amplification circuit including an electro-optical conversion unit according to this application;

FIG. 10b is a diagram of an eighth photoelectric amplification circuit including an electro-optical conversion unit according to this application;

FIG. 11a is a diagram of a ninth photoelectric amplification circuit including an electro-optical conversion unit according to this application;

FIG. 11b is a diagram of a tenth photoelectric amplification circuit including an electro-optical conversion unit according to this application;

FIG. 12a is a diagram of an eleventh photoelectric amplification circuit including an electro-optical conversion unit according to this application;

FIG. 12b is a diagram of a twelfth photoelectric amplification circuit including an electro-optical conversion unit according to this application;

FIG. 13 is a diagram of a photoelectric amplification circuit including an electro-optical conversion unit and a matching network according to this application;

FIG. 14 is a diagram of a photoelectric amplification circuit including an electro-optical conversion unit and an electrical phase compensation line according to this application;

FIG. 15 is a diagram of a photoelectric amplification circuit including an electro-optical conversion unit, a matching network, and an electrical phase compensation line according to this application;

FIG. 16 is a schematic flowchart of a signal processing method according to this application;

FIG. 17 is a diagram of an apparatus according to this application; and

FIG. 18 is a diagram of a device according to this application.

## DESCRIPTION OF EMBODIMENTS

The following describes technical solutions of this application with reference to accompanying drawings.

A photoelectric amplification circuit provided in embodiments of this application may be used in a base station system, a satellite communication system, a radar system, an optical sensing system, and the like. For example, when the photoelectric amplification circuit is used in the base station system, the photoelectric amplification circuit may be a part of a circuit structure in a radio frequency signal amplification apparatus of a base station, and is configured to amplify a signal of the base station. For another example, when the photoelectric amplification circuit is used in the satellite communication system, the photoelectric amplification circuit may be a part of a circuit structure in a satellite signal amplification apparatus, and may be configured to amplify a satellite signal, or may implement amplification of a communication signal between satellites. For still another example, when the photoelectric amplification circuit is used in the radar system, the photoelectric amplification circuit may be a part of a circuit structure in a signal amplification apparatus of a lidar, and is configured to amplify a signal of the lidar. A specific application scenario is not limited in this application.

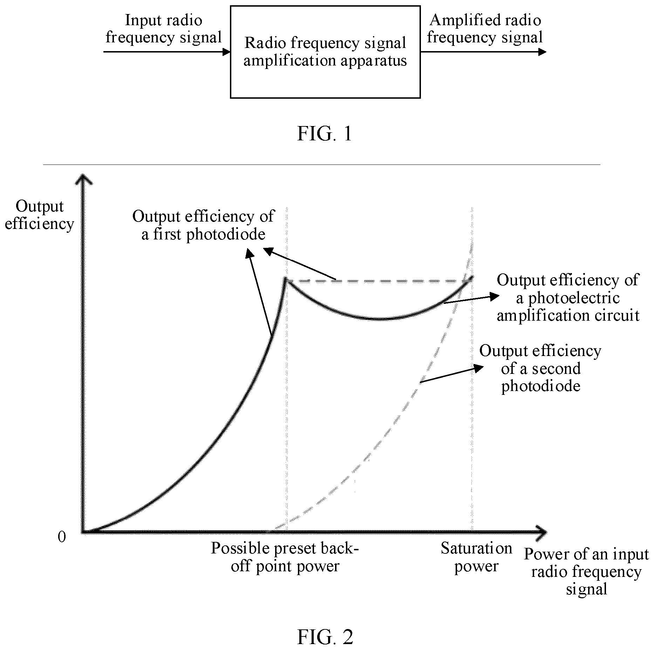

An application scenario of a radio frequency signal amplification apparatus in a base station system is used as an example for description in the following. The radio frequency signal amplification apparatus is a core component of a wireless communication system, and performance of the apparatus directly affects a transmission distance and transmission quality of a signal. Therefore, indicators such as linearity and current efficiency need to be considered to meet an application requirement of the base station system. For example, FIG. 1 is a diagram of a radio frequency signal amplification apparatus in a base station system. An input end of the radio frequency signal amplification apparatus receives an input radio frequency signal (power of the input radio frequency signal is low), and an output end outputs an amplified radio frequency signal. Based on this, embodiments of this application provide a plurality of photoelectric amplification circuits and a signal processing method. The plurality of photoelectric amplification circuits provided in this application may be modules (or chips) in the radio frequency signal amplification apparatus. A Doherty circuit structure based on a high-power photodiode (photodiode, PD) is used, so that power supply efficiency of the high-power PD in a back-off state is improved, and an ultra-wideband feature is considered, to help flexibly deploy all services in a full frequency band of a base station and reduce costs. According to the signal processing method, dynamic load conversion of the high-power PD from a back-off point to a maximum output point can be implemented, so that the high-power PD maintains high back-off efficiency in a large back-off range.

1. Related concepts in this application

1) Base station system:
The base station system mentioned in this application includes a network device, and the network device may be a device that can communicate with a terminal device. The network device may be a base station, a relay station, or an access point. The base station may be a base transceiver station (base transceiver station, BTS) in a global system for mobile communication (global system for mobile communication, GSM) or a code division multiple access (code division multiple access, CDMA) network, or may be a 3G base station NodeB in a wideband code division multiple access (wideband code division multiple access, WCDMA) system, or may be an evolutional NodeB (eNB or eNodeB for short) in a long term evolution (long term evolution, LTE) system. The network device may alternatively be a satellite in a satellite communication system. The network device may alternatively be a radio controller in a cloud radio access network (cloud radio access network, CRAN) scenario. The network device may alternatively be a network device in a 5G network or a network device (for example, a gNodeB) in a future evolved public land mobile network (public land mobile network, PLMN). The network device may alternatively be a wearable device, an unmanned aerial vehicle, a device in the internet of vehicles (for example, a vehicle to everything (vehicle to everything, V2X) device), a communication device in device to device (device to device, D2D) communication, or a network device used in a future communication system.

2) A photodiode (photodiode, PD) includes an input end and an output end, where the input end is configured to receive an optical signal, and the output end is configured to output a radio frequency signal. In other words, the photodiode is configured to: convert an optical signal into a radio frequency signal, and output the radio frequency signal.

3) An impedance modulation unit is configured to adjust, based on input signal power of a high-power PD, an impedance load presented by the high-power PD at the output end, so that the high-power PD maintains high back-off efficiency in a large back-off range. The impedance modulation unit may be, for example, a 1/4 wavelength impedance converter.

For example, when input optical power of the high-power PD is low, the high-power PD presents a high impedance load (for example, greater than a load impedance of the high-power PD at maximum input power) at the output end by using the impedance modulation unit; or when input optical power of the high-power PD is high, the high-power PD presents an optimal impedance load at the output end by using the impedance modulation unit.

4) Preset back-off point power, saturation power, and power back-off value:

To ensure that an output radio frequency signal of the photoelectric amplification circuit can meet signal quality needed by a wireless communication system, power of a radio frequency signal input to the photoelectric amplification circuit needs to reach at least the preset back-off point power. Currently, an orthogonal frequency division multiplexing (orthogonal frequency division multiplexing, OFDM) technology is usually used as a standard solution for signal modulation in the wireless communication system, and a peak-to-average ratio of an OFDM signal changes within a specific linear dynamic range. When the peak-to-average ratio of the OFDM signal exceeds the linear dynamic range, non-linear distortion of the signal is caused. In this case, transmission performance of the OFDM signal is affected. In this application, to avoid non-linear distortion of a radio frequency signal and make output efficiency of a first photodiode and a second photodiode high, the preset back-off point power is determined. This helps maintain high output efficiency of the first photodiode and the second photodiode in an interval between the saturation power and the preset back-off point power.

The preset back-off point power is power of an input radio frequency signal when a first radio frequency signal and a second radio frequency signal that are output by the first photodiode and the second photodiode meet preset signal quality. The input radio frequency signal is a radio frequency signal input to the photoelectric amplification circuit. Specifically, the preset back-off point power is determined based on the saturation power and the power back-off value. The saturation power is power of the input radio frequency signal when output power of the first photodiode and output power of the second photodiode are maximum. The power back-off value is determined based on a peak-to-average ratio of the input radio frequency signal and the preset signal quality. For example, when the peak-to-average ratio of the input radio frequency signal increases, the power back-off value also increases.

For example, FIG. 2 is a diagram of a relationship between power and output efficiency of an input radio frequency signal according to this application. FIG. 2 shows an output efficiency curve of a first photodiode, an output efficiency curve of a second photodiode, and an output efficiency curve of a photoelectric amplification circuit. FIG. 2 further shows a possible preset back-off point power and saturation power. When the power of the input radio frequency signal is low, it is assumed in this application that the first photodiode works and the second photodiode does not work. When the power of the input radio frequency signal gradually increases from 0, power of an input optical signal of the first photodiode also gradually increases, and output efficiency of the first photodiode also gradually increases, as shown in FIG. 2. When the output efficiency of the first photodiode reaches a maximum value (in other words, when output power of the first photodiode is a maximum value), power of a corresponding input radio frequency signal may be considered as a possible preset back-off point power. It should be noted that, in the figure, when the power of the input optical signal of the first photodiode is less than the preset back-off point power (in other words, when the first photodiode works and the second photodiode does not work), the output efficiency curve of the first photodiode overlaps the output efficiency curve of the photoelectric amplification circuit. In other words, when the power of the input radio frequency signal is equal to the preset back-off point power, the first photodiode works in a saturation state. When the power of the input radio frequency signal further increases, the second photodiode also starts to work. Power of an input optical signal of the second photodiode also increases as the power of the input radio frequency signal increases, and output efficiency of the second photodiode also gradually increases, as shown in FIG. 2. When the output efficiency of the second photodiode reaches a maximum value (in other words, when output power of the second photodiode is a maximum value), power of a corresponding input radio frequency signal may be considered as the saturation power. In other words, when the power of the input radio frequency signal is equal to the saturation power, both the first photodiode and the second photodiode work in the saturation state.

In a possible implementation, the power of the input radio frequency signal may be less than or equal to the preset back-off point power. For example, when the power of the input radio frequency signal is equal to the preset back-off point power, the output efficiency of the photoelectric amplification circuit may be equal to the maximum value of the output efficiency of the first photodiode, as shown in FIG. 2. When the power of the input radio frequency signal is less than the preset back-off point power, the output efficiency of the photoelectric amplification circuit is less than the maximum value of the output efficiency of the first photodiode, but in this case, compared with linearity of an output radio frequency signal when the power of the input radio frequency signal is equal to the preset back-off point power, linearity of the output radio frequency signal is improved. In other words, when the power of the input radio frequency signal is less than the preset back-off point power, the output efficiency of the photoelectric amplification circuit is reduced, but the linearity of the output radio frequency signal is improved.

In another possible implementation, the preset back-off point power is further determined based on a modulation scheme of the input radio frequency signal. The modulation scheme of the input radio frequency signal includes modulation schemes such as quadrature amplitude modulation (quadrature amplitude modulation, QAM) and phase-shift keying (phase-shift keying, PSK) modulation (for example, QPSK and 8PSK). For example, if a 64QAM modulation scheme is used, the preset back-off point power may be set to 12 dB; if a 16QAM modulation scheme is used, the preset back-off point power may be set to 9 dB; or if the QPSK modulation scheme is used, the preset back-off point power may be set to 4 dB. This embodiment does not limit the specific value that is set.

5) The electro-optical conversion unit is configured to: receive an input radio frequency signal, convert the input radio frequency signal into an optical signal, and amplify the optical signal, to amplify a radio frequency signal in optical domain, to help meet a requirement of a back-end antenna for radiating a microwave signal. The electro-optical conversion unit in embodiments of this application may include but is not limited to the following modules: an electrical power splitter, a laser, an optical amplifier, a laser source, an optical power splitter, an optical splitter, an optical power controller, and the like. For a specific implementation, refer to descriptions in the following embodiments.

2. Photoelectric amplification circuit provided in this application

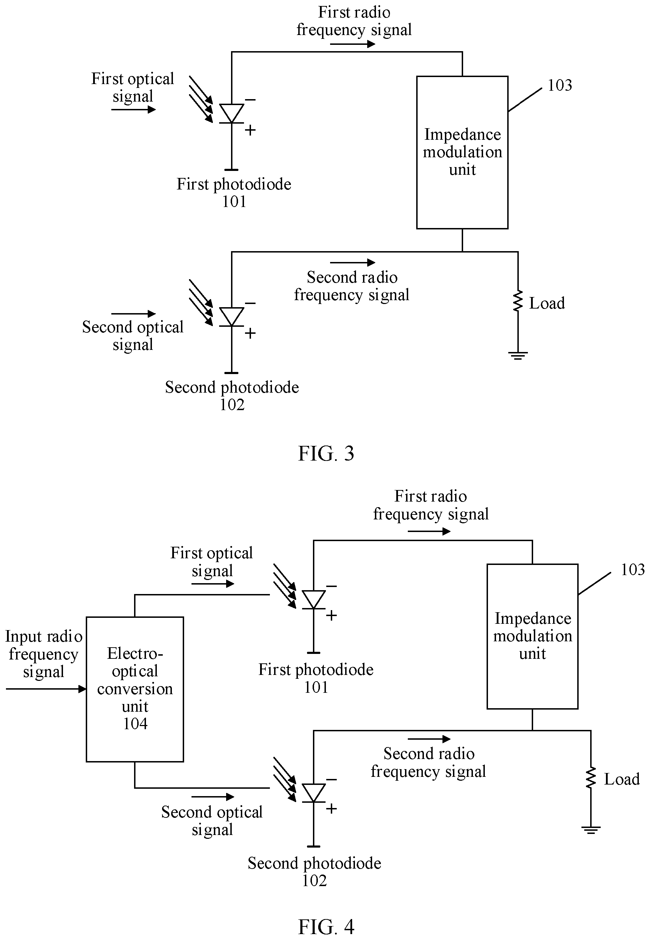

FIG. 3 is a diagram of a photoelectric amplification circuit according to this application. The photoelectric amplification circuit may be used in the radio frequency signal amplification apparatus in the base station system shown in FIG. 1. For example, the photoelectric amplification circuit may be a final stage of a radio frequency transmit link that is based on a radio frequency photonic architecture. The photoelectric amplification circuit includes a first photodiode 101 (referred to as a first PD for short below), a second photodiode 102 (referred to as a second PD for short below), and an impedance modulation unit 103. It may be understood that the photoelectric amplification circuit further includes a load, where the load may include, for example, a resistor, a capacitor, an inductor, or an antenna unit, and may further include a ground part.

The first PD includes a first input end and a first output end. The first input end is configured to receive a first optical signal, and the first output end is configured to output a first radio frequency signal. The second PD includes a second input end and a second output end. The second input end is configured to receive a second optical signal, and the second output end is configured to output a second radio frequency signal. It may be understood that the first PD and the second PD are in a parallel connection relationship, and are respectively located on two parallel circuits, as shown in FIG. 3. The first optical signal and the second optical signal are two optical signals obtained by processing an input radio frequency signal. For example, the first optical signal and the second optical signal may be obtained by performing processing such as splitting, electro-optical conversion, and amplification on the input radio frequency signal. For a specific processing manner, refer to detailed descriptions of an electro-optical conversion unit in the following embodiments.

In a possible implementation, the first PD is a carrier high-power PD, and the second PD is a peak high-power PD. In this application, it is assumed that offset of the carrier high-power PD is in class AB/B, and offset of the peak high-power PD is in class C. In other words, the first PD and the second PD work in different states. Class AB indicates that a current output interval of a PD device is between a periodicity of a half sine wave and a periodicity of an entire sine wave. Class B indicates that the current output interval of the PD device is only the periodicity of the half sine wave. Class C indicates that the current output interval of the PD device is less than the periodicity of the half sine wave. For example, when power of the input radio frequency signal is low (for example, less than or equal to preset back-off point power), the first PD works (to be specific, the first PD outputs the first radio frequency signal), and the second PD is cut off and does not work (to be specific, the second PD does not output the second radio frequency signal). For another example, when the power of the input radio frequency signal is high (for example, greater than or equal to the preset back-off point power), the first PD works (to be specific, the first PD outputs the first radio frequency signal), the second PD also works (to be specific, the second PD outputs the second radio frequency signal), and the first radio frequency signal and the second radio frequency signal are combined into a final output signal.

The impedance modulation unit is connected to the first PD, and is connected to the second PD. It should be noted that the connection described in this application may be a direct connection. For example, the first PD shown in FIG. 3 is directly connected to the impedance modulation unit through a circuit. Alternatively, a circuit for connection may further include another component. For example, an inductor, a resistor, a matching network, or the like may be further included between the first PD and the impedance modulation unit. This is not limited in this application. The impedance modulation unit is configured to adjust, based on input signal power of the first PD and/or input signal power of the second PD, impedance loads/an impedance load presented by the first PD and/or the second PD at output ends/an output end.

In a possible implementation, when power of a radio frequency signal modulated to the first optical signal is greater than or equal to the preset back-off point power, the impedance modulation unit is configured to: modulate an impedance of the first output end to a first impedance and modulate an impedance of the second output end to the first impedance based on the first optical signal and the second optical signal. The first impedance is a corresponding impedance when output power of the first photodiode and output power of the second photodiode are maximum. For example, when the power of the input radio frequency signal is high (for example, greater than or equal to the preset back-off point power), the first PD works, and the second PD also works. In this case, the impedance modulation unit modulates, by using an active load modulation function of the second PD, the impedance of the first output end of the first PD to a corresponding impedance when the output power of the first PD is maximum; and modulates the impedance of the second output end of the second PD to a corresponding impedance when the output power of the second PD is maximum. It may be understood that, in this application, the first PD and the second PD are in the parallel connection relationship. In this case, when the output power of the first PD and the output power of the second PD are the same, the first PD and the second PD reach maximum output power, and corresponding impedances when the output power of the first PD and the output power of the second PD are maximum are also the same. In other words, the impedance of the first output end of the first PD and the impedance of the second output end of the second PD are the same, and are the first impedance.

In another possible implementation, when the power of the radio frequency signal modulated to the first optical signal is less than or equal to the preset back-off point power, the impedance modulation unit is configured to modulate the impedance of the first output end to a second impedance based on power of the first optical signal, where the second impedance is greater than or equal to the first impedance, and the second impedance needs to meet that when the power of the input radio frequency signal is less than or equal to the preset back-off point power, efficiency of the first PD may be greater than or equal to the first impedance. For example, when the power of the input radio frequency signal is low (for example, less than or equal to the preset back-off point power), the first PD works, and the second PD is cut off and does not work. In this case, the circuit on which the second PD is located may be considered as an open circuit (for example, the impedance of the second output end of the second PD is presented as infinity). In this case, all input radio frequency signals are modulated to the first optical signal, so that the output power of the first PD gradually increases, and the impedance of the first output end of the first PD also gradually increases to the second impedance.

It may be understood that, in the foregoing two implementations, when the power of the radio frequency signal modulated to the first optical signal is equal to the preset back-off point power, the impedance modulation unit may modulate the impedance of the first output end in any one of the implementations. This is not limited in this application.

3. An electro-optical conversion unit is newly added on the basis of the photoelectric amplification circuit described in the second part.

FIG. 4 is a diagram of a photoelectric amplification circuit including an electro-optical conversion unit according to this application. In comparison with the photoelectric amplification circuit shown in FIG. 3, the photoelectric amplification circuit has a newly added electro-optical conversion unit 104. The electro-optical conversion unit is connected to a first input end of a first PD, and is connected to a second input end of a second PD. The electro-optical conversion unit is configured to process an input radio frequency signal to obtain a first optical signal and a second optical signal. For example, the electro-optical conversion unit may perform processing such as splitting, electro-optical conversion, and amplification on the input radio frequency signal, to obtain two optical signals (to be specific, obtain the first optical signal and the second optical signal).

In a possible implementation, when power of a radio frequency signal modulated to the first optical signal is less than or equal to preset back-off point power, the electro-optical conversion unit is further configured to control power of the second optical signal to be 0. For example, based on the descriptions in the second part provided above, when the power of the radio frequency signal modulated to the first optical signal is less than or equal to the preset back-off point power, the first PD works, and the second PD is cut off and does not work. In this case, the electro-optical conversion unit controls the power of the second optical signal to be 0, so that the second PD is cut off and does not work.

In another possible implementation, when the power of the radio frequency signal modulated to the first optical signal is greater than or equal to the preset back-off point power, the electro-optical conversion unit is further configured to increase the power of the second optical signal. For example, based on the descriptions in the second part provided above, when the power of the radio frequency signal modulated to the first optical signal is greater than or equal to the preset back-off point power, the first PD works, and the second PD also works. In this case, the electro-optical conversion unit increases the power of the second optical signal, so that the second PD can start to work.

The electro-optical conversion unit in this application may have a plurality of specific implementations, which are described in detail below.

Implementation 1: An electro-optical conversion unit includes an electrical power splitter 104a, a first laser 104b, a second laser 104c, a first optical amplifier 104d, and a second optical amplifier 104e.

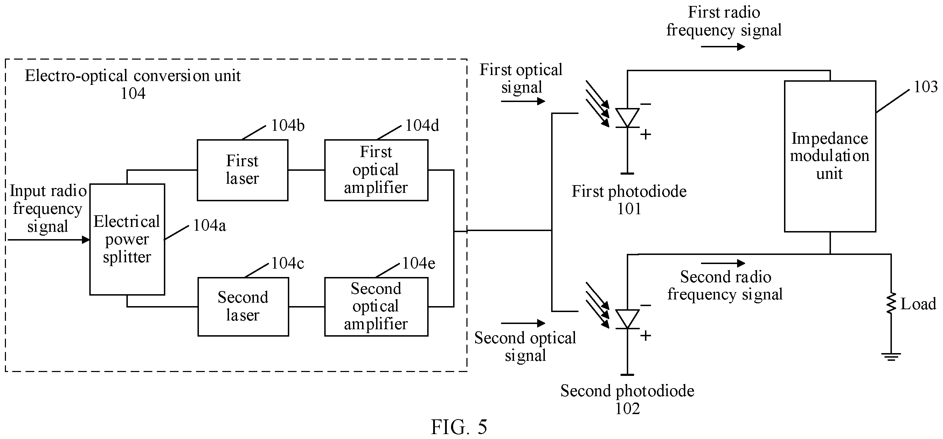

Connection relationships between components in Implementation 1 include: The electrical power splitter is connected to the first laser, and is connected to the second laser, the first laser is connected to the first optical amplifier, and the second laser is connected to the second optical amplifier, as shown in FIG. 5. It may be understood that the first optical amplifier and the second optical amplifier may be located at an output end of the electro-optical conversion unit. For example, the first optical amplifier is connected to a first input end of a first PD, and the second optical amplifier is connected to a second input end of a second PD.

The electrical power splitter is configured to split an input radio frequency signal into a first input radio frequency signal and a second input radio frequency signal based on a preset proportion. Specifically, the preset proportion $\beta$ is determined based on a maximum efficiency back-off amount $\alpha$ , $\beta$ meets $\beta = 10^{\frac{\alpha}{2}} - 1$ , and a unit of $\alpha$ is dB. For example, when $\alpha$ = 6dB, the preset proportion is 1:1, to be specific, power of the first input radio frequency signal is the same as power of the second input radio frequency signal. For another example, when $\alpha$ = 9dB , the preset proportion is 1:2, to be specific, the power of the first input radio frequency signal is half of the power of the second input radio frequency signal. For still another example, when $\alpha$ = 12dB, the preset proportion is 1:3, to be specific, the power of the first input radio frequency signal is 1/3 of the power of the second input radio frequency signal. It can be learned that the electrical power splitter may be used to split one input radio frequency signal into two parallel input radio frequency signals, so that a subsequent component can separately process the two signals.

The first laser and the second laser are in a parallel connection relationship, and are both configured to convert a radio frequency signal into an optical signal. For example, the first laser is configured to convert the first input radio frequency signal into a first input optical signal, and the second laser is configured to convert the second input radio frequency signal into a second input optical signal. Specifically, the first laser and the second laser may be directly modulated electro-optical modulators, or may be externally modulated electro-optical modulators. A specific implementation is described in detail below.

The first optical amplifier and the second optical amplifier are in a parallel connection relationship, and are both configured to amplify an optical signal, so that an amplified optical signal can be converted into an amplified radio frequency signal, to meet a requirement of a back-end antenna for radiating a microwave signal. For example, the first optical amplifier is configured to: amplify the first input optical signal to obtain a first optical signal, and output the first optical signal. The second optical amplifier is configured to: amplify the second input optical signal to obtain a second optical signal, and output the second optical signal.

It may be understood that, in Implementation 1, the first laser, the first optical amplifier, and the first PD are in a serial connection relationship, and may form one radio frequency photonic amplification link; and the second laser, the second optical amplifier, and the second PD are in a serial connection relationship, and may form another radio frequency photonic amplification link. The laser, the optical amplifier, and the PD may be connected through an optical fiber, and may be extended to a kilometer level; or may be connected through a circuit. This is not limited in this application.

Implementation 2: An electro-optical conversion unit includes an electrical power splitter 104a, a first laser 104b, a second laser 104c, an optical amplifier 104d, an optical multiplexer 104f, and an optical demultiplexer 104g.

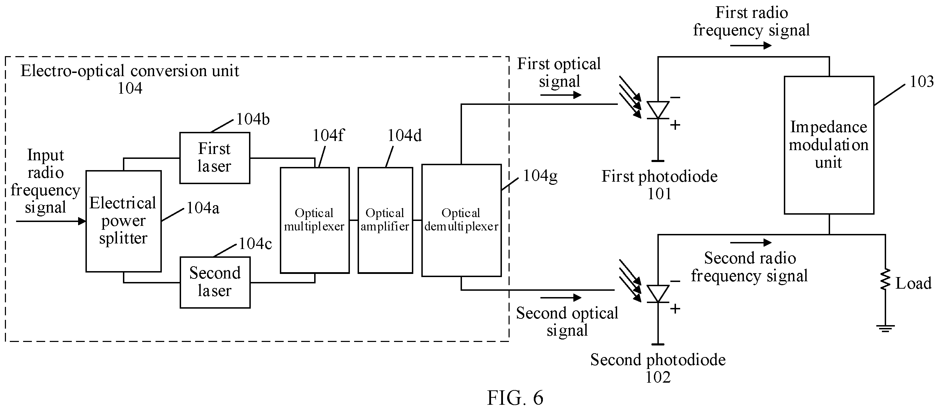

Connection relationships between components in Implementation 2 include: The electrical power splitter is connected to the first laser, and is connected to the second laser; the first laser is connected to the optical multiplexer, and the second laser is connected to the optical multiplexer; and the optical multiplexer is connected to the optical amplifier, and the optical amplifier is connected to the optical demultiplexer, as shown in FIG. 6. It may be understood that the optical demultiplexer may be located at an output end of the electro-optical conversion unit. For example, the optical demultiplexer is connected to a first input end of a first PD, and is connected to a second input end of a second PD.

The optical multiplexer is configured to multiplex a plurality of optical signals to a same channel. For example, the optical multiplexer is configured to multiplex a first input optical signal and a second input optical signal to a same channel. The optical demultiplexer is configured to demultiplex different optical signals in a same channel to a plurality of different channels. For example, the optical demultiplexer is configured to demultiplex a first optical signal and a second optical signal that are in a same channel to two different channels. It may be understood that, different from Implementation 1 in which two optical amplifiers are used to respectively amplify two optical signals, Implementation 2 in which only one optical amplifier is used reduces usage of active devices, to help reduce power consumption of a circuit; and the optical multiplexer and the optical demultiplexer are added, so that the two optical signals can be amplified.

For function descriptions of the electrical power splitter, the laser, and the optical amplifier, refer to corresponding descriptions in Implementation 1. Details are not described herein again. It may be understood that the laser, the optical multiplexer, the optical amplifier, and the optical demultiplexer may be connected through an optical fiber, and may be extended to a kilometer level; or may be connected through a circuit. This is not limited in this application.

Implementation 3: An electro-optical conversion unit includes a laser 104b, an optical splitter 104h, an optical power controller 104i, a first optical amplifier 104d, and a second optical amplifier 104e.

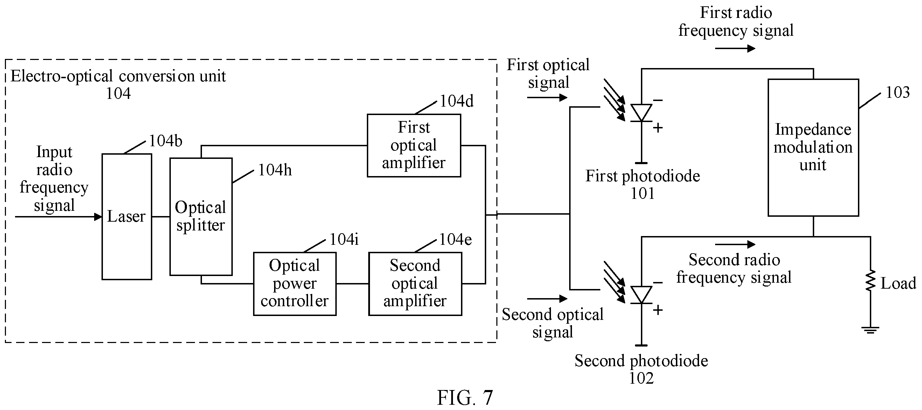

Connection relationships between components in Implementation 3 include: The laser is connected to the optical splitter; the optical splitter is connected to the first optical amplifier; and the optical splitter is connected to the optical power controller, and the optical power controller is connected to the second optical amplifier, as shown in FIG. 7.

The optical splitter is configured to split one optical signal into a plurality of optical signals. For example, the optical splitter 104h may split one optical signal output by the laser 104b into two optical signals: a first input optical signal and a second input optical signal. Because power of the first input optical signal and power of the second input optical signal may be the same, an optical power controller (for example, may be a light saturated absorber) is newly added to the photoelectric amplification circuit shown in FIG. 7, so that average optical power of the first input optical signal is different from average optical power of the second input optical signal. For example, assuming that the average optical power of the first input optical signal and the average optical power of the second input optical signal that are output by the optical splitter 104h in FIG. 7 are the same, and the optical power controller 104i and the second optical amplifier 104e are in a serial connection relationship, the power of the second input optical signal may be adjusted, so that average optical power of an adjusted second input optical signal and the average optical power of the first input optical signal are different.

For function descriptions of the laser and the optical amplifier, refer to corresponding descriptions in Implementation 1. Details are not described herein again. It may be understood that the laser, the optical splitter, the optical power controller, and the optical amplifier may be connected through an optical fiber, and may be extended to a kilometer level; or may be connected through a circuit. This is not limited in this application.

Implementation 4: An electro-optical conversion unit includes a laser 104b, an optical splitter 104h, an optical power controller 104i, an optical amplifier 104d, an optical multiplexer 104f, and an optical demultiplexer 104g.

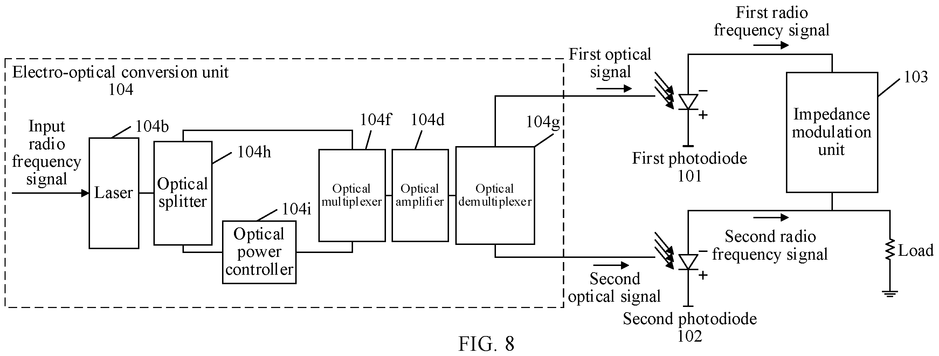

Connection relationships between components in Implementation 4 include: The laser is connected to the optical splitter; the optical splitter is connected to the optical power controller; the optical multiplexer is connected to the optical splitter, and is connected to the optical power controller; the optical multiplexer is connected to the optical amplifier; and the optical amplifier is connected to the optical demultiplexer, as shown in FIG. 8.

For function descriptions of the laser, the optical splitter, the optical power controller, the optical amplifier, the optical multiplexer, and the optical demultiplexer, refer to corresponding descriptions in Implementation 1 to Implementation 3. Details are not described herein again. It may be understood that the laser, the optical splitter, the optical power controller, the optical amplifier, the optical multiplexer, and the optical demultiplexer may be connected through an optical fiber, and may be extended to a kilometer level; or may be connected through a circuit. This is not limited in this application.

It should be noted that, when any electro-optical conversion unit in Implementation 1 to Implementation 4 is used, if different types of lasers are used, structures of electro-optical conversion units may be different.

1. When any laser in Implementation 1 to Implementation 4 is a directly modulated electro-optical modulator, the structure of the electro-optical conversion unit and a corresponding photoelectric amplification circuit may be shown in FIG. 5 to FIG. 8. Details are not described herein again.

2. When any laser in Implementation 1 to Implementation 4 is an externally modulated electro-optical modulator, because the externally modulated electro-optical modulator needs laser input to convert a radio frequency signal into an optical signal, the electro-optical conversion unit further includes a laser source. The laser source is connected to the laser, and the laser source is configured to provide laser light for the laser, to enable the laser to convert an input radio frequency signal into an input optical signal.

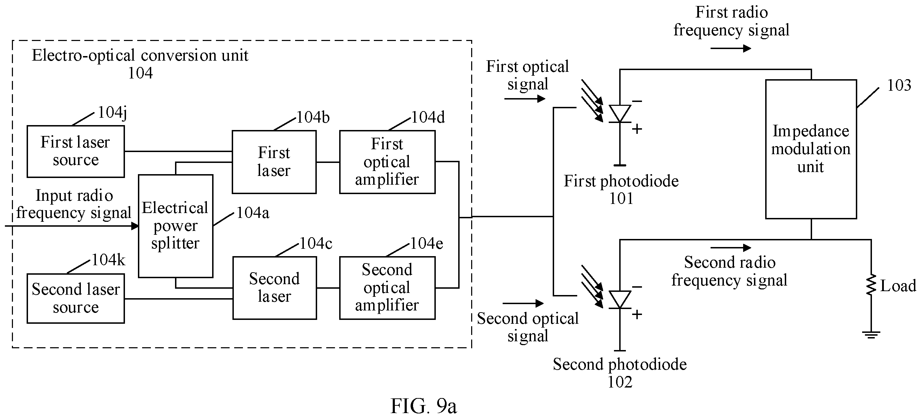

In a first possible implementation, when the first laser and the second laser in Implementation 1 are externally modulated electro-optical modulators, the electro-optical conversion unit and the corresponding photoelectric amplification circuit are shown in FIG. 9a. In comparison with the electro-optical conversion unit in FIG. 5, the electro-optical conversion unit shown in FIG. 9a further includes a first laser source 104j and a second laser source 104k, so that an externally modulated electro-optical modulator can convert a radio frequency signal into an optical signal. The first laser source is connected to the first laser, and is configured to provide laser light for the first laser, to enable the first laser to convert a first input radio frequency signal into a first input optical signal. The second laser source is connected to the second laser, and is configured to provide laser light for the second laser, to enable the second laser to convert a second input radio frequency signal into a second input optical signal.

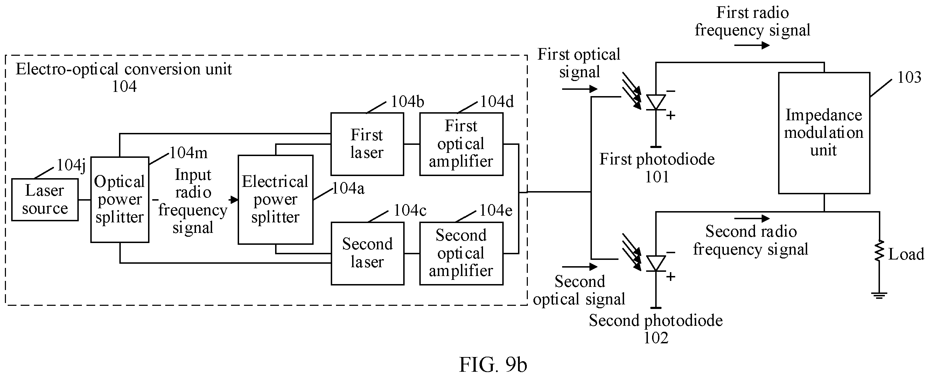

In a second possible implementation, when the first laser and the second laser in Implementation 1 are externally modulated electro-optical modulators, the electro-optical conversion unit and the corresponding photoelectric amplification circuit are shown in FIG. 9b. In comparison with the electro-optical conversion unit in FIG. 5, the electro-optical conversion unit shown in FIG. 9b further includes a laser source 104j and an optical power splitter 104m. In comparison with the electro-optical conversion unit in FIG. 9a, the electro-optical conversion unit shown in FIG. 9b has only one laser source, which reduces usage of active devices, and helps reduce power consumption of a circuit; and one optical power splitter is used to split laser light, to obtain two channels of laser light, and transmit the two channels of laser light to the first laser and the second laser respectively, so that the externally modulated electro-optical modulator can convert a radio frequency signal into an optical signal.

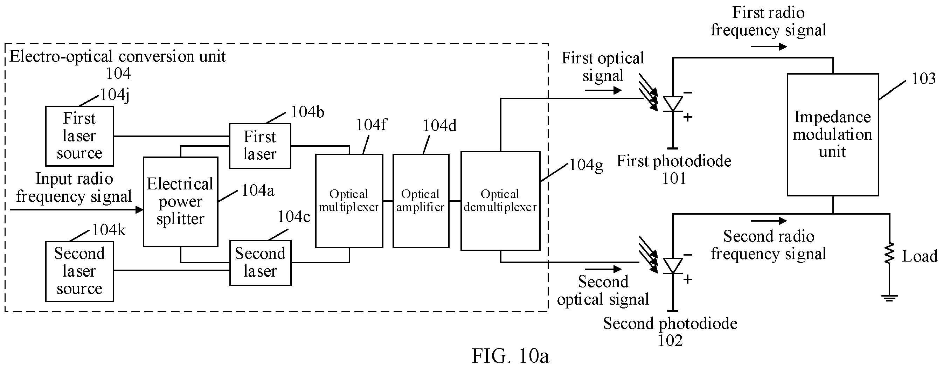

In a third possible implementation, when the first laser and the second laser in Implementation 2 are externally modulated electro-optical modulators, the electro-optical conversion unit and the corresponding photoelectric amplification circuit are shown in FIG. 10a. In comparison with the electro-optical conversion unit in FIG. 6, the electro-optical conversion unit shown in FIG. 10a further includes a first laser source 104j and a second laser source 104k, so that the externally modulated electro-optical modulator can convert a radio frequency signal into an optical signal. For connection relationships and functions of the first laser source, the second laser source, the first laser, and the second laser, refer to descriptions in the first possible implementation. Details are not described herein again.

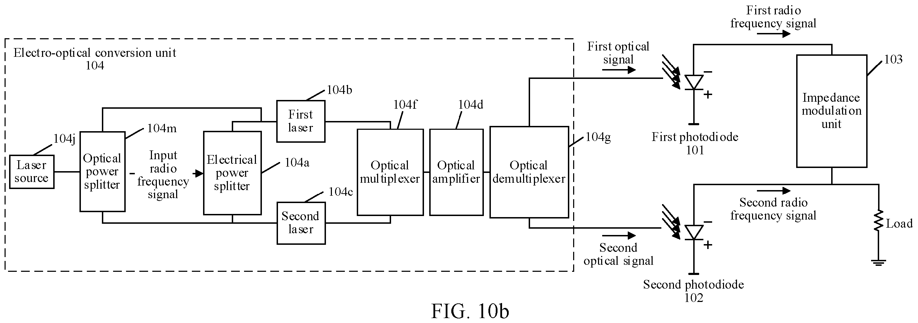

In a fourth possible implementation, when the first laser and the second laser in Implementation 2 are externally modulated electro-optical modulators, the electro-optical conversion unit and the corresponding photoelectric amplification circuit are shown in FIG. 10b. In comparison with the electro-optical conversion unit in FIG. 6, the electro-optical conversion unit shown in FIG. 10b further includes a laser source 104j and an optical power splitter 104m. In comparison with the electro-optical conversion unit in FIG. 10a, the electro-optical conversion unit shown in FIG. 10b has only one laser source, which reduces usage of active devices, and helps reduce power consumption of a circuit; and one optical power splitter is used to split laser light, to obtain two channels of laser light, and transmit the two channels of laser light to the first laser and the second laser respectively, so that the externally modulated electro-optical modulator can convert a radio frequency signal into an optical signal.

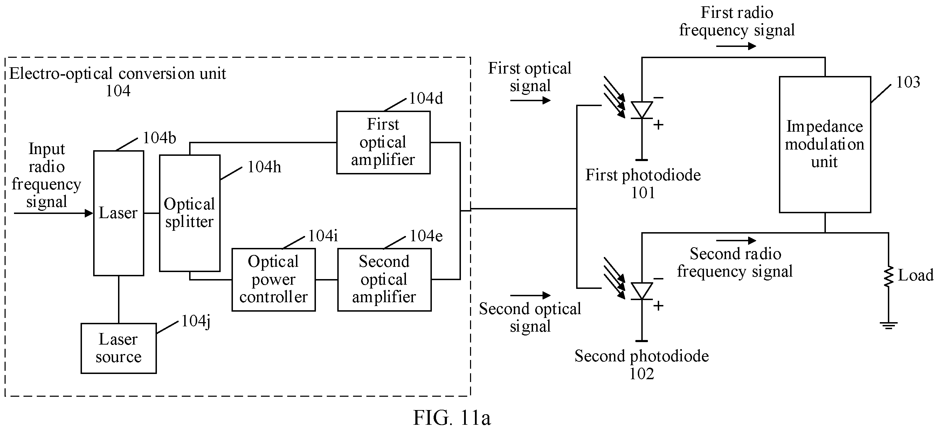

In a fifth possible implementation, when the laser in Implementation 3 is an externally modulated electro-optical modulator, the electro-optical conversion unit and the corresponding photoelectric amplification circuit are shown in FIG. 11a. In comparison with the electro-optical conversion unit in FIG. 7, the electro-optical conversion unit shown in FIG. 11a further includes a laser source 104j, so that the externally modulated electro-optical modulator can convert a radio frequency signal into an optical signal. The laser source is connected to the laser, and is configured to provide laser light for the laser, to enable the laser to convert an input radio frequency signal into one optical signal.

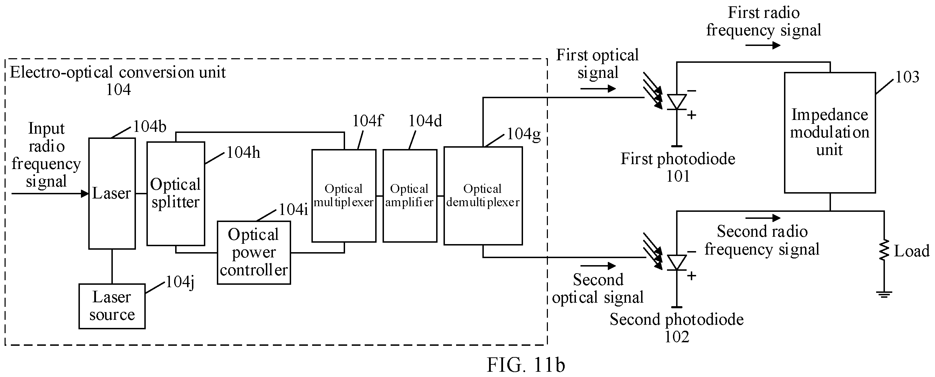

In a sixth possible implementation, when the laser in Implementation 4 is an externally modulated electro-optical modulator, the electro-optical conversion unit and the corresponding photoelectric amplification circuit are shown in FIG. 11b. In comparison with the electro-optical conversion unit in FIG. 8, the electro-optical conversion unit shown in FIG. 11b further includes a laser source 104j, so that the externally modulated electro-optical modulator can convert a radio frequency signal into an optical signal. The laser source is connected to the laser, and is configured to provide laser light for the laser, to enable the laser to convert an input radio frequency signal into one optical signal.

Optionally, in the photoelectric amplification circuit that includes the electro-optical conversion unit and that is described in FIG. 5 to FIG. 11b, the electro-optical conversion unit may further include a first optical delayer and a second optical delayer. The first optical delayer and the second optical delayer are configured to align a phase of a first optical signal with a phase of a second optical signal.

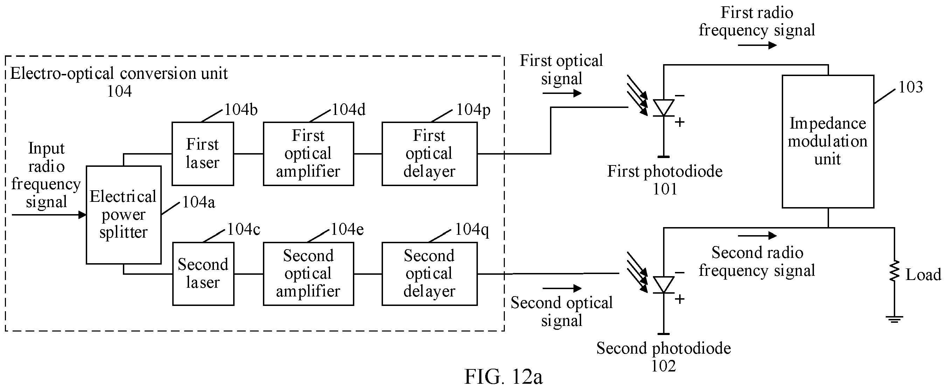

In a possible implementation, when the electro-optical conversion unit includes a first optical amplifier and a second optical amplifier, the first optical amplifier is connected to the first optical delayer, and the first optical delayer is connected to a first input end of a first PD; and the second optical amplifier is connected to the second optical delayer, and the second optical delayer is connected to a second input end of a second PD. In other words, the first optical delayer and the second optical delayer are in a parallel connection relationship. For example, the electro-optical conversion unit shown in FIG. 5 is used as an example. When the electro-optical conversion unit includes a first optical delayer 104p and a second optical delayer 104q, connection relationships between the first optical delayer, the second optical delayer, and other components are shown in FIG. 12a. It can be learned that when a phase of an optical signal output by the first optical amplifier is not aligned with a phase of an optical signal output by the second optical amplifier, a phase of a first optical signal may be aligned with a phase of a second optical signal by using the first optical delayer and the second optical delayer, so that transmission paths of the first optical signal and the second optical signal are consistent.

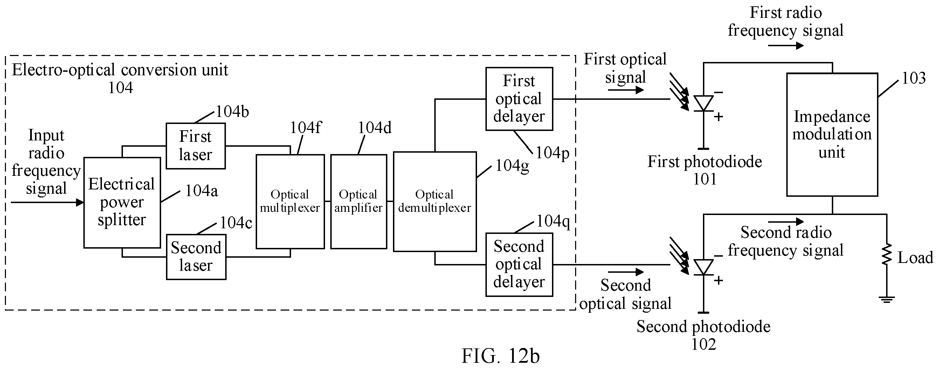

In another possible implementation, when the electro-optical conversion unit includes an optical multiplexer, an optical amplifier, and an optical demultiplexer, the optical demultiplexer is connected to the first optical delayer, and is connected to the second optical delayer. The first optical delayer is connected to the first input end of the first PD, and the second optical delayer is connected to the second input end of the second PD. In other words, the first optical delayer and the second optical delayer are in a parallel connection relationship. For example, the electro-optical conversion unit shown in FIG. 6 is used as an example. When the electro-optical conversion unit includes a first optical delayer and a second optical delayer, connection relationships between the first optical delayer, the second optical delayer, and other components are shown in FIG. 12b.

It may be understood that the electro-optical conversion unit in FIG. 6 to FIG. 11b may alternatively include the first optical delayer and the second optical delayer. For a specific implementation, refer to the implementations in FIG. 12a and FIG. 12b. Details are not described herein again.

4. A matching network and/or an electrical phase compensation line are/is added on the basis of the photoelectric amplification circuit described in the second part and the third part.

The photoelectric amplification circuit shown in FIG. 3 to FIG. 12b mainly describes an electro-optical conversion unit, a first PD, a second PD, and an impedance modulation unit. Optionally, a matching network and/or an electrical phase compensation line may be further included between the first PD, the second PD, and the impedance modulation unit.

Implementation 1: A photoelectric amplification circuit includes a matching network.

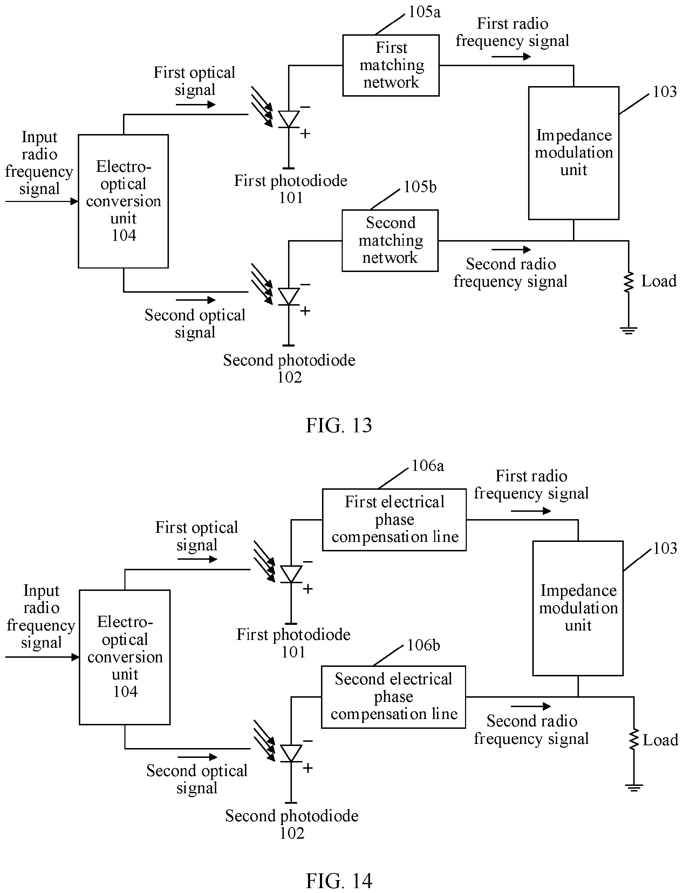

The matching network is configured to implement impedance matching between output ends of the first PD and the second PD and a subsequent circuit. For example, FIG. 13 is a diagram of a photoelectric amplification circuit including an electro-optical conversion unit and a matching network according to this application. In comparison with the photoelectric amplification circuit shown in FIG. 4, the photoelectric amplification circuit has a first matching network 105a and a second matching network 105b that are newly added. A first output end of the first PD is connected to the first matching network, the first matching network is connected to an impedance modulation unit, and the first matching network is configured to implement impedance matching between the first output end and the circuit. A second output end of the second PD is connected to the second matching network, the second matching network is connected to the impedance modulation unit, and the second matching network is configured to implement impedance matching between the second output end and the circuit.

Implementation 2: A photoelectric amplification circuit includes an electrical phase compensation line.

The electrical phase compensation line is configured to adjust phases of radio frequency signals output by a first PD and a second PD. For example, FIG. 14 is a diagram of a photoelectric amplification circuit including an electro-optical conversion unit and an electrical phase compensation line according to this application. In comparison with the photoelectric amplification circuit shown in FIG. 4, the photoelectric amplification circuit has a first electrical phase compensation line 106a and a second electrical phase compensation line 106b that are newly added. A first output end of the first PD is connected to the first electrical phase compensation line, the first electrical phase compensation line is connected to an impedance modulation unit, and the first electrical phase compensation line is configured to adjust a phase of a first radio frequency signal. A second output end of the second PD is connected to the second electrical phase compensation line, the second electrical phase compensation line is connected to the impedance modulation unit, and the second electrical phase compensation line is configured to adjust a phase of a second radio frequency signal.

Implementation 3: A photoelectric amplification circuit includes a matching network and an electrical phase compensation line.

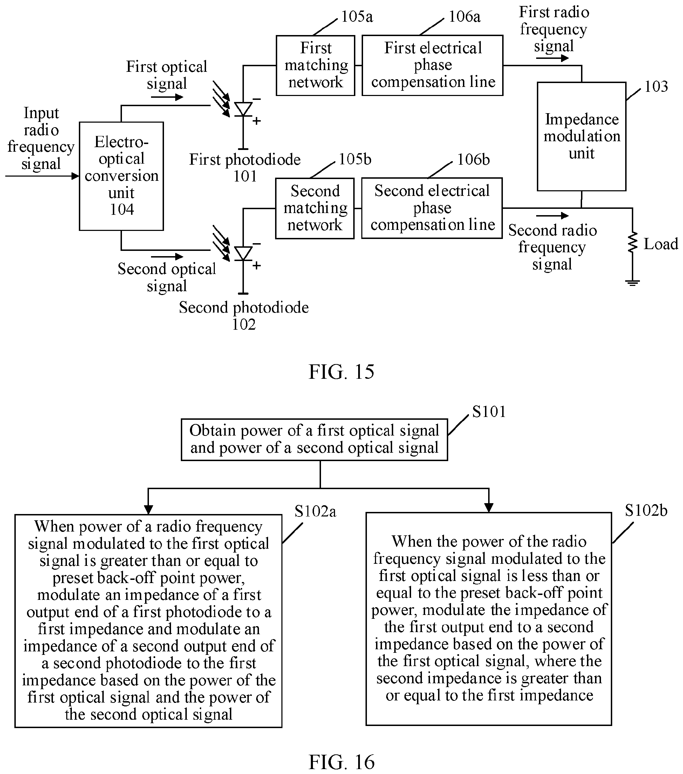

For example, FIG. 15 is a diagram of a photoelectric amplification circuit including an electro-optical conversion unit, a matching network, and an electrical phase compensation line according to this application. In comparison with the photoelectric amplification circuit shown in FIG. 4, the photoelectric amplification circuit has a first matching network 105a, a second matching network 105b, a first electrical phase compensation line 106a, and a second electrical phase compensation line 106b that are newly added. Connection relationships between components are shown in FIG. 15, and functions described in Implementation 1 and Implementation 2 can be implemented. Details are not described herein again.

It may be understood that a matching network and an electrical phase compensation line may alternatively be included in FIG. 3 and FIG. 5 to FIG. 12b described in the foregoing embodiments. For a specific implementation, refer to corresponding descriptions in FIG. 13 to FIG. 15. Details are not described herein again.

5. Signal processing method provided in this application

For example, FIG. 16 is a schematic flowchart of a signal processing method according to this application. The signal processing method may be executed by the radio frequency signal amplification apparatus shown in FIG. 1, and include the following steps.

S101: Obtain power of a first optical signal and power of a second optical signal.

The first optical signal and the second optical signal are two optical signals obtained by processing an input radio frequency signal. For example, when the radio frequency signal amplification apparatus includes the electro-optical conversion unit shown in any one of FIG. 4 to FIG. 15, the radio frequency signal amplification apparatus may perform processing such as splitting, electro-optical conversion, and amplification on the input radio frequency signal by using the electro-optical conversion unit, to obtain the first optical signal and the second optical signal. For a specific implementation, refer to descriptions in the embodiments corresponding to FIG. 4 to FIG. 15. Details are not described herein again.

S102a: When power of a radio frequency signal modulated to the first optical signal is greater than or equal to preset back-off point power, modulate an impedance of a first output end of a first photodiode to a first impedance and modulate an impedance of a second output end of a second photodiode to the first impedance based on the power of the first optical signal and the power of the second optical signal.

The first impedance is a corresponding impedance when output power of the first photodiode and output power of the second photodiode are maximum. For example, when the radio frequency signal amplification apparatus includes the impedance modulation unit shown in any one of FIG. 3 to FIG. 15, if the power of the radio frequency signal modulated to the first optical signal is greater than or equal to the preset back-off point power, the radio frequency signal amplification apparatus may modulate the impedance of the first output end of the first PD and the impedance of the second output end of the second PD to the same first impedance by using the impedance modulation unit. For a specific implementation, refer to the descriptions of the function of the impedance modulation unit in the second part. Details are not described herein again.

S102b: When the power of the radio frequency signal modulated to the first optical signal is less than or equal to the preset back-off point power, modulate the impedance of the first output end to a second impedance based on the power of the first optical signal, where the second impedance is greater than or equal to the first impedance.

For example, when the radio frequency signal amplification apparatus includes the impedance modulation unit shown in any one of FIG. 3 to FIG. 15, if the power of the radio frequency signal modulated to the first optical signal is less than or equal to the preset back-off point power, the radio frequency signal amplification apparatus may modulate the impedance of the first output end of the first PD to the second impedance by using the impedance modulation unit. In addition, in this case, the impedance of the second output end of the second PD is presented as infinite. For a specific implementation, refer to the descriptions of the function of the impedance modulation unit in the second part. Details are not described herein again.

In a possible implementation, the radio frequency signal amplification apparatus may further perform the following steps:

when the power of the radio frequency signal modulated to the first optical signal is less than or equal to the preset back-off point power, controlling the power of the second optical signal to be 0; or
when the power of the radio frequency signal modulated to the first optical signal is greater than or equal to the preset back-off point power, increasing the power of the second optical signal.

For example, when the radio frequency signal amplification apparatus includes the electro-optical conversion unit shown in any one of FIG. 4 to FIG. 15, if the power of the radio frequency signal modulated to the first optical signal is less than or equal to the preset back-off point power, the radio frequency signal amplification apparatus may control, by using the electro-optical conversion unit, the power of the second optical signal to be 0. Alternatively, if the power of the radio frequency signal modulated to the first optical signal is greater than or equal to the preset back-off point power, the radio frequency signal amplification apparatus may increase the power of the second optical signal by using the electro-optical conversion unit. For a specific implementation, refer to the descriptions of the function of the electro-optical conversion unit in the third part. Details are not described herein again.

According to the signal processing method provided in this application, the impedance of the first photodiode and the impedance of the second photodiode are adjusted to implement dynamic load conversion from a back-off point to a maximum output point. This helps maintain high output efficiency of the first photodiode and the second photodiode in an interval between the maximum power point and the back-off point.

To implement the functions in the method provided in this application, the apparatus or the device provided in this application may include a hardware structure and/or a software module, to implement the foregoing functions in a form of the hardware structure, the software module, or a combination of the hardware structure and the software module. Whether a function in the foregoing functions is performed by using the hardware structure, the software module, or the combination of the hardware structure and the software module depends on particular applications and design constraints of the technical solutions. The module division in this application is an example, and is merely logical function division. There may be another division manner during actual implementation. In addition, functional modules in embodiments of this application may be integrated into one processor, or may exist alone physically, or two or more modules may be integrated into one module. The foregoing integrated module may be implemented in a form of hardware, or may be implemented in a form of a software function module.

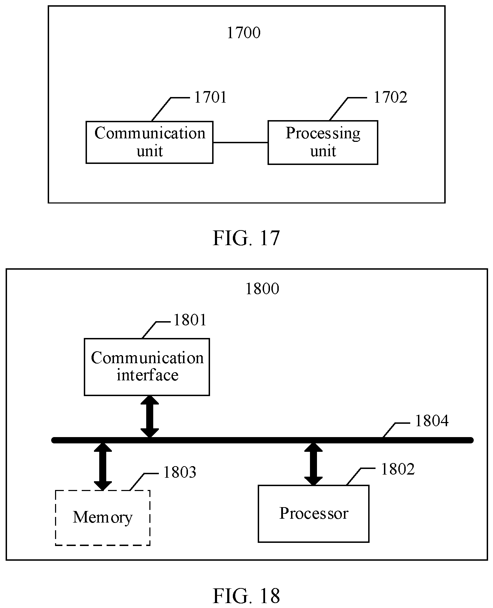

FIG. 17 shows an apparatus 1700 according to this application. The apparatus may include a one-to-one corresponding module for performing the method/operation/step/action described in the method embodiment corresponding to FIG. 16. The module may be implemented by a hardware circuit, software, or a hardware circuit in combination with software.

In a possible implementation, the apparatus includes a communication unit 1701 and a processing unit 1702, and is configured to implement the method performed by the radio frequency signal amplification apparatus in the foregoing embodiments. The communication unit 1701 is configured to obtain power of a first optical signal and power of a second optical signal. The processing unit 1702 is configured to: when power of a radio frequency signal modulated to the first optical signal is greater than or equal to preset back-off point power, modulate an impedance of a first output end of a first photodiode to a first impedance and modulate an impedance of a second output end of a second photodiode to the first impedance based on the power of the first optical signal and the power of the second optical signal. For a specific execution procedure of the communication unit 1701 and the processing unit 1702 in this example, refer to the detailed descriptions of the signal processing method in the foregoing embodiment. Details are not described herein again. In the signal processing method implemented by the apparatus, the impedance of the first photodiode and the impedance of the second photodiode are adjusted to implement dynamic load conversion from a back-off point to a maximum output point. This helps maintain high output efficiency of the first photodiode and the second photodiode in an interval between the maximum power point and the back-off point.

Optionally, the processing unit 1702 is configured to: when the power of the radio frequency signal modulated to the first optical signal is less than or equal to the preset back-off point power, modulate the impedance of the first output end to a second impedance based on the power of the first optical signal, where the second impedance is greater than or equal to the first impedance.

Optionally, when the power of the radio frequency signal modulated to the first optical signal is less than or equal to the preset back-off point power, the power of the second optical signal is controlled to be 0.

Alternatively, when the power of the radio frequency signal modulated to the first optical signal is greater than or equal to the preset back-off point power, the power of the second optical signal is increased.

The following describes a device including a plurality functional units shown in FIG. 17. The device in this application includes the plurality of functional units shown in FIG. 17, and may alternatively include the photoelectric amplification circuit shown in FIG. 3 to FIG. 15. For example, FIG. 18 shows a device 1800 according to this application, and the device 1800 is configured to implement the signal processing method in the foregoing method embodiment. The device 1800 may alternatively be a chip system. The device 1800 includes a communication interface 1801 and a processor 1802. The communication interface 1801 may be, for example, a transceiver, an interface, a bus, a circuit, or an apparatus that can implement receiving and sending functions. The communication interface 1801 is configured to communicate with another device by using a transmission medium, so that the device 1800 can communicate with the another device. The processor 1802 and the communication interface 1801 are configured to implement the method in the embodiment corresponding to FIG. 16.

For example, the communication interface 1801 and the processor 1802 are configured to implement the signal processing method in the foregoing embodiment. The communication interface 1801 is configured to obtain power of a first optical signal and power of a second optical signal. The processor 1802 is configured to: when power of a radio frequency signal modulated to the first optical signal is greater than or equal to preset back-off point power, modulate an impedance of a first output end of a first photodiode to a first impedance and modulate an impedance of a second output end of a second photodiode to the first impedance based on the power of the first optical signal and the power of the second optical signal. For a specific execution procedure of the communication interface 1801 and the processor 1802 in this example, refer to the detailed descriptions of the signal processing method in the foregoing embodiment. Details are not described herein again. In the signal processing method implemented by the device, the impedance of the first photodiode and the impedance of the second photodiode are adjusted to implement dynamic load conversion from a back-off point to a maximum output point. This helps maintain high output efficiency of the first photodiode and the second photodiode in an interval between the maximum power point and the back-off point.

Optionally, the device may further include at least one memory 1803, configured to store program instructions and/or data. In an implementation, the memory is coupled to the processor. Couplings in this application are indirect couplings or communication connections between apparatuses, units, or modules, and may be electrical, mechanical, or in another form, and are used for information exchange between the apparatuses, the units, and the modules. The processor may perform an operation in collaboration with the memory. The processor may execute the program instructions stored in the memory. The at least one memory and the processor are integrated together.

A specific connection medium between the communication interface, the processor, and the memory is not limited in this application. For example, the memory, the processor, and the communication interface are connected through a bus. The bus is represented by a bold line in FIG. 18. A manner of connection between other components is merely an example for description, and is not construed as a limitation. The bus may be classified into an address bus, a data bus, a control bus, and the like. For ease of representation, only one bold line is used to represent the bus in FIG. 18, but this does not mean that there is only one bus or only one type of bus.

In this application, the processor may be a general-purpose processor, a digital signal processor, an application-specific integrated circuit, a field programmable gate array or another programmable logic device, a discrete gate or a transistor logic device, or a discrete hardware component, and may implement or perform the methods, steps, and logical block diagrams disclosed in this application. The general-purpose processor may be a microprocessor or any conventional processor or the like. The steps of the methods disclosed with reference to this application may be directly implemented by a hardware processor, or may be implemented by a combination of hardware and a software module in a processor.

In this application, the memory may be a nonvolatile memory, for example, a hard disk drive (hard disk drive, HDD) or a solid-state drive (solid-state drive, SSD), or may be a volatile memory (volatile memory), for example, a random-access memory (random-access memory, RAM). The memory is any other medium that can carry or store expected program code in a form of instructions or a data structure and that can be accessed by a computer, but is not limited thereto. The memory in this application may alternatively be a circuit or any other apparatus that can implement a storage function, and is configured to store program instructions and/or data.

This application provides a computer-readable storage medium. The computer-readable storage medium stores a program or instructions. When the program or the instructions is/are run on a computer, the computer is enabled to perform the signal processing method in the embodiment corresponding to FIG. 16.

This application provides a computer program product. The computer program product includes instructions. When the instructions are run on a computer, the computer is enabled to perform the signal processing method in the embodiment corresponding to FIG. 16.

This application provides a chip or a chip system. The chip or the chip system includes at least one processor and an interface. The interface is interconnected with the at least one processor through a line. The at least one processor is configured to run a computer program or instructions, to perform the signal processing method in the embodiment corresponding to FIG. 16.

The interface in the chip may be an input/output interface, a pin, a circuit, or the like.

The chip system may be a system on chip (system on chip, SOC), a baseband chip, or the like. The baseband chip may include a processor, a channel encoder, a digital signal processor, a modem, an interface module, and the like.

In an implementation, the chip or the chip system described above in this application further includes at least one memory, and the at least one memory stores instructions. The memory may be a storage unit inside the chip, for example, a register or a cache, or may be a storage unit (for example, a read-only memory or a random access memory) of the chip.

All or some of the technical solutions provided in this application may be implemented by using software, hardware, firmware, or any combination thereof. When the software is used to implement the technical solutions, all or a part of the technical solutions may be implemented in a form of a computer program product. The computer program product includes one or more computer instructions. When the computer program instructions are loaded and executed on the computer, the procedure or functions according to this application are all or partially generated. The computer may be a general-purpose computer, a dedicated computer, a computer network, a network device, a terminal device, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer or a data storage device, for example, a server or a data center, integrating one or more usable media. The usable medium may be a magnetic medium (for example, a floppy disk, a hard disk drive, or a magnetic tape), an optical medium (for example, a digital video disc (digital video disc, DVD)), a semiconductor medium, or the like.

In this application, without a logical contradiction, mutual reference can be made between embodiments. For example, mutual reference can be made between methods and/or terms in method embodiments, mutual reference can be made between functions and/or terms in apparatus embodiments, and mutual reference can be made between functions and/or terms in the apparatus embodiments and the method embodiments.

It is clear that a person skilled in the art can make various modifications and variations to this application without departing from the scope of this application. This application is intended to cover these modifications and variations of this application provided that they fall within the scope of protection defined by the following claims and their equivalent technologies.

**Claims**

1. A photoelectric amplification circuit, wherein the photoelectric amplification circuit comprises a first photodiode, a second photodiode, and an impedance modulation unit, wherein

the first photodiode comprises a first input end and a first output end, wherein the first input end is configured to receive a first optical signal, and the first output end is configured to output a first radio frequency signal;
the second photodiode comprises a second input end and a second output end, wherein the second input end is configured to receive a second optical signal, and the second output end is configured to output a second radio frequency signal, wherein
the first optical signal and the second optical signal are two optical signals obtained by processing an input radio frequency signal;
the impedance modulation unit is connected to the first photodiode, and is connected to the second photodiode; and
when power of a radio frequency signal modulated to the first optical signal is greater than or equal to preset back-off point power, the impedance modulation unit is configured to: modulate an impedance of the first output end to a first impedance and modulate an impedance of the second output end to the first impedance based on power of the first optical signal and power of the second optical signal, wherein

the first impedance is a corresponding impedance when output power of the first photodiode and output power of the second photodiode are maximum.

2. The circuit according to claim 1, wherein the preset back-off point power is power of the input radio frequency signal when the first radio frequency signal and the second radio frequency signal that are output by the first photodiode and the second photodiode meet preset signal quality; and
the preset back-off point power is determined based on saturation power and a power back-off value.

3. The circuit according to claim 2, wherein the saturation power is power of the input radio frequency signal when the output power of the first photodiode and the output power of the second photodiode are maximum; and
the power back-off value is determined based on a peak-to-average ratio of the input radio frequency signal and the preset signal quality.

4. The circuit according to claim 2 or 3, wherein the preset back-off point power is further determined based on a modulation scheme of the input radio frequency signal; and
the modulation scheme of the input radio frequency signal comprises quadrature amplitude modulation and/or phase-shift keying modulation.

5. The circuit according to any one of claims 1 to 4, wherein
when the power of the radio frequency signal modulated to the first optical signal is less than or equal to the preset back-off point power, the impedance modulation unit is configured to modulate the impedance of the first output end to a second impedance based on the power of the first optical signal, wherein the second impedance is greater than or equal to the first impedance.

6. The circuit according to any one of claims 1 to 4, wherein the photoelectric amplification circuit further comprises an electro-optical conversion unit, wherein

the electro-optical conversion unit is connected to the first input end, and is connected to the second input end;
the electro-optical conversion unit is configured to process the input radio frequency signal to obtain the first optical signal and the second optical signal; and
when the power of the radio frequency signal modulated to the first optical signal is less than or equal to the preset back-off point power, the electro-optical conversion unit is further configured to control the power of the second optical signal to be 0; or
when the power of the radio frequency signal modulated to the first optical signal is greater than or equal to the preset back-off point power, the electro-optical conversion unit is further configured to increase the power of the second optical signal.

7. The circuit according to claim 6, wherein the electro-optical conversion unit comprises an electrical power splitter, a first laser, a second laser, a first optical amplifier, and a second optical amplifier, wherein

the electrical power splitter is connected to the first laser, and is connected to the second laser;
the electrical power splitter is configured to split the input radio frequency signal into a first input radio frequency signal and a second input radio frequency signal based on a preset proportion;
the first laser is configured to: receive the first input radio frequency signal, and convert the first input radio frequency signal into a first input optical signal;
the second laser is configured to: receive the second input radio frequency signal, and convert the second input radio frequency signal into a second input optical signal;
the first laser is connected to the first optical amplifier, and the first optical amplifier is connected to the first input end;
the second laser is connected to the second optical amplifier, and the second optical amplifier is connected to the second input end;
the first optical amplifier is configured to: amplify the first input optical signal to obtain the first optical signal, and output the first optical signal; and
the second optical amplifier is configured to: amplify the second input optical signal to obtain the second optical signal, and output the second optical signal.

8. The circuit according to claim 6, wherein the electro-optical conversion unit comprises an electrical power splitter, a first laser, a second laser, an optical multiplexer, an optical amplifier, and an optical demultiplexer, wherein

the electrical power splitter is connected to the first laser, and is connected to the second laser;
the electrical power splitter is configured to split the input radio frequency signal into a first input radio frequency signal and a second input radio frequency signal based on a preset proportion;
the first laser is configured to: receive the first input radio frequency signal, and convert the first input radio frequency signal into a first input optical signal;

the second laser is configured to: receive the second input radio frequency signal, and convert the second input radio frequency signal into a second input optical signal;

the optical multiplexer is connected to the first laser, and is connected to the second laser;

the optical multiplexer is configured to multiplex the first input optical signal and the second input optical signal to a same channel;

the optical multiplexer is connected to the optical amplifier, and the optical amplifier is connected to the optical demultiplexer;

the optical amplifier is configured to amplify the first input optical signal and the second input optical signal to obtain the first optical signal and the second optical signal;

the optical demultiplexer is configured to demultiplex the first optical signal and the second optical signal that are in the same channel to two different channels; and

the optical demultiplexer is connected to the first input end, and is connected to the second input end.

9. The circuit according to claim 7 or 8, wherein the first laser and the second laser are directly modulated electro-optical modulators.

10. The circuit according to claim 7 or 8, wherein the first laser and the second laser are externally modulated electro-optical modulators, and

the electro-optical conversion unit further comprises a first laser source and a second laser source, wherein

the first laser source is connected to the first laser, and is configured to provide laser light for the first laser, to enable the first laser to convert the first input radio frequency signal into the first input optical signal; and

the second laser source is connected to the second laser, and is configured to provide laser light for the second laser, to enable the second laser to convert the second input radio frequency signal into the second input optical signal; or

the electro-optical conversion unit further comprises a laser source and an optical power splitter, wherein

the laser source is connected to the optical power splitter, and the optical power splitter is connected to the first laser and the second laser; and

the laser source and the optical power splitter are configured to provide laser sources for the first laser and the second laser, to enable the first laser to convert the first input radio frequency signal into the first input optical signal, and enable the second laser to convert the second input radio frequency signal into the second input optical signal.

11. The circuit according to claim 6, wherein the electro-optical conversion unit comprises a laser, an optical splitter, an optical power controller, a first optical amplifier, and a second optical amplifier, wherein

the laser is connected to the optical splitter;

the laser is configured to: receive the input radio frequency signal, and convert the input radio frequency signal into an optical signal;

the optical splitter is configured to split the optical signal into a first input optical signal and a second input optical signal;

the optical splitter is connected to the first optical amplifier, and the first optical amplifier is connected to the first input end;

the first optical amplifier is configured to: amplify the first input optical signal to obtain the first optical signal, and output the first optical signal;

the optical splitter is connected to the optical power controller, the optical power controller is connected to the second optical amplifier, and the second optical amplifier is connected to the second input end;

the optical power controller is configured to control the second input optical signal, to enable power of the second input optical signal to be different from power of the first input optical signal; and

the second optical amplifier is configured to: amplify the second input optical signal to obtain the second optical signal, and output the second optical signal.

12. The circuit according to claim 6, wherein the electro-optical conversion unit comprises a laser, an optical splitter, an optical power controller, an optical multiplexer, an optical amplifier, and an optical demultiplexer, wherein

the laser is connected to the optical splitter;

the laser is configured to: receive the input radio frequency signal, and convert the input radio frequency signal into an optical signal;

the optical splitter is configured to split the optical signal into a first input optical signal and a second input optical signal;

the optical splitter is connected to the optical power controller, and is connected to the optical multiplexer;

the optical power controller is connected to the optical multiplexer;

the optical power controller is configured to control the second input optical signal, to enable power of the second input optical signal to be different from power of the first input optical signal;

the optical multiplexer is configured to multiplex the first input optical signal and the second input optical signal to a same channel;

the optical multiplexer is connected to the optical amplifier, and the optical amplifier is connected to the optical demultiplexer;

the optical amplifier is configured to amplify the first input optical signal and the second input optical signal to obtain the first optical signal and the second optical signal;

the optical demultiplexer is configured to demultiplex the first optical signal and the second optical signal that are in the same channel to two different channels; and

the optical demultiplexer is connected to the first input end, and is connected to the second input end.

13. The circuit according to claim 11 or 12, wherein the laser is a directly modulated laser, or the laser is an externally modulated electro-optical modulator; and

when the laser is the externally modulated electro-optical modulator, the electro-optical conversion unit further comprises a laser source, wherein
the laser source is connected to the laser, and is configured to provide a laser source for the laser, to enable the laser to convert the input radio frequency signal into an optical signal.

14. The circuit according to any one of claims 6 to 13, wherein the electro-optical conversion unit further comprises a first optical delayer and a second optical delayer, wherein

the first optical amplifier is connected to the first optical delayer, and the second optical amplifier is connected to the second optical delayer; or
the optical demultiplexer is connected to the first optical delayer, and is connected to the second optical delayer;
the first optical delayer is connected to the first input end;
the second optical delayer is connected to the second input end; and
the first optical delayer and the second optical delayer are configured to align a phase of the first optical signal with a phase of the second optical signal.

15. The circuit according to any one of claims 1 to 14, wherein the photoelectric amplification circuit further comprises a first matching network and a second matching network, wherein

the first matching network is connected to the first output end, and is configured to implement impedance matching between the first output end and the circuit; and
the second matching network is connected to the second output end, and is configured to implement impedance matching between the second output end and the circuit.

16. The circuit according to any one of claims 1 to 15, wherein the photoelectric amplification circuit further comprises a first electrical phase compensation line and a second electrical phase compensation line, wherein

the first electrical phase compensation line is connected to the impedance modulation unit, and is configured to adjust a phase of the first radio frequency signal;
the second electrical phase compensation line is connected to the impedance modulation unit, and is configured to adjust a phase of the second radio frequency signal; and
the phase of the first radio frequency signal is the same as the phase of the second radio frequency signal.

17. A signal processing method, wherein the method comprises:

obtaining power of a first optical signal and power of a second optical signal, wherein the first optical signal and the second optical signal are two optical signals obtained by processing an input radio frequency signal; and
when power of a radio frequency signal modulated to the first optical signal is greater than or equal to preset back-off point power, modulating an impedance of a first output end of the first photodiode to a first impedance and modulating an impedance of a second output end of the second photodiode to the first impedance based on the power of the first optical signal and the power of the second optical signal, wherein
the first impedance is a corresponding impedance when output power of the first photodiode and output power of the second photodiode are maximum.

18. The method according to claim 17, wherein the preset back-off point power is power of the input radio frequency signal when a first radio frequency signal and a second radio frequency signal that are output by the first photodiode and the second photodiode meet preset signal quality; and

the preset back-off point power is determined based on saturation power and a power back-off value.

19. The method according to claim 18, wherein the saturation power is power of the input radio frequency signal when the output power of the first photodiode and the output power of the second photodiode are maximum; and
the power back-off value is determined based on a peak-to-average ratio of the input radio frequency signal and the preset signal quality.

20. The method according to claim 18 or 19, wherein the preset back-off point power is further determined based on a modulation scheme of the input radio frequency signal; and
the modulation scheme of the input radio frequency signal comprises quadrature amplitude modulation and/or phase-shift keying modulation.

21. The method according to any one of claims 17 to 20, wherein the method further comprises:
when the power of the radio frequency signal modulated to the first optical signal is less than or equal to the preset back-off point power, modulating the impedance of the first output end to a second impedance based on the power of the first optical signal, wherein the second impedance is greater than or equal to the first impedance.

22. The method according to claims 17 to 20, wherein the method further comprises:

when the power of the radio frequency signal modulated to the first optical signal is less than or equal to the preset back-off point power, controlling the power of the second optical signal to be 0; or
when the power of the radio frequency signal modulated to the first optical signal is greater than or equal to the preset back-off point power, increasing the power of the second optical signal.

23. An apparatus, comprising a unit or a module configured to perform the method according to any one of claims 17 to 22.

24. A device, comprising a processor and a memory, wherein the memory is coupled to the processor, and the processor is configured to perform the method according to any one of claims 17 to 22.

25. A computer-readable storage medium, configured to store instructions, wherein when the instructions are run on a computer, the computer is enabled to perform the method according to any one of claims 17 to 22.

26. A computer program product, comprising instructions, wherein when the instructions are run on a computer, the computer is enabled to perform the method according to any one of claims 17 to 22.

27. An apparatus, comprising the photoelectric amplification circuit according to any one of claims 1 to 16.

28. A chip system, comprising a processor, wherein the processor is configured to perform the method according to any one of claims 17 to 22.

Input radio frequency signal → Radio frequency signal amplification apparatus → Amplified radio frequency signal

FIG. 1

Output efficiency

Output efficiency of a first photodiode

Output efficiency of a photoelectric amplification circuit

Output efficiency of a second photodiode

0

Possible preset back-off point power

Saturation power

Power of an input radio frequency signal

FIG. 2

First radio
frequency signal

First optical
signal

First photodiode
101

Impedance
modulation
unit

103

Second radio
frequency signal

Load

Second optical
signal

Second photodiode
102

FIG. 3

First radio
frequency signal

First optical
signal

Input radio
frequency
signal

Electro-
optical
conversion
unit
104

First photodiode
101

Impedance
modulation
unit

103

Second radio
frequency signal

Load

Second optical
signal

Second photodiode
102

FIG. 4

FIG. 5

FIG. 6

FIG. 7

FIG. 8

EP 4 521 658 A1

FIG. 9a

FIG. 9b

First radio
frequency signal

Electro-optical conversion unit
104

104j

First
laser
source

Input radio
frequency signal

104b

First
laser

104f        104d

104a

Electrical
power
splitter

104c

Second
laser
source

104k

Second
laser

Optical
multiplexer

Optical
amplifier

Optical
demultiplexer

104g

First optical
signal

First photodiode
101

−
+

Second
optical signal

Second photodiode
102

Second radio
frequency signal

−
+

Impedance
modulation
unit

103

Load

FIG. 10a

EP 4 521 658 A1

FIG. 10b

EP 4 521 658 A1

FIG. 11a

EP 4 521 658 A1

FIG. 11b

Impedance modulation unit — 103

Load

First radio frequency signal

Second radio frequency signal

First optical signal

Second optical signal

First photodiode 101

Second photodiode 102

Electro-optical conversion unit 104

Input radio frequency signal

Laser — 104b

Optical splitter — 104h

Optical power controller — 104i

Laser source — 104j

Optical multiplexer — 104f

Optical amplifier — 104d

Optical demultiplexer — 104g

FIG. 12a

EP 4 521 658 A1

FIG. 12b

Electro-optical conversion unit 104

Input radio frequency signal

Electrical power splitter 104a

First laser 104b

Second laser 104c

Optical multiplexer 104f

Optical amplifier 104d

Optical demultiplexer 104g

First optical delayer 104p

Second optical delayer 104q

First optical signal

Second optical signal

First photodiode 101

Second photodiode 102

First radio frequency signal

Second radio frequency signal

Impedance modulation unit 103

Load

FIG. 13

FIG. 14

First radio
frequency
signal

105a        106a

First
matching
network

First electrical
phase
compensation line

First optical
signal

Input
radio
frequency
signal

Electro-
optical
conversion
unit
104

First photodiode
101

Impedance
modulation
unit

103

105b        106b

Second
matching
network

Second electrical
phase
compensation line

Second optical
signal

Second radio
frequency
signal

Load

Second photodiode
102

FIG. 15

Obtain power of a first optical signal
and power of a second optical signal

S101

When power of a radio frequency
signal modulated to the first optical
signal is greater than or equal to
preset back-off point power,
modulate an impedance of a first
output end of a first photodiode to a
first impedance and modulate an
impedance of a second output end of
a second photodiode to the first
impedance based on the power of the
first optical signal and the power of
the second optical signal

S102a

When the power of the radio
frequency signal modulated to the
first optical signal is less than or
equal to the preset back-off point
power, modulate the impedance of
the first output end to a second
impedance based on the power of
the first optical signal, where the
second impedance is greater than
or equal to the first impedance

S102b

FIG. 16

1700

1701

Communication unit

1702

Processing unit

FIG. 17

1800

1801

Communication interface

1804

1803

Memory

1802

Processor

FIG. 18

## INTERNATIONAL SEARCH REPORT

| International application No. |
|---|
| **PCT/CN2023/091372** |

### A. CLASSIFICATION OF SUBJECT MATTER

H04B10/291(2013.01)i

According to International Patent Classification (IPC) or to both national classification and IPC

### B. FIELDS SEARCHED

Minimum documentation searched (classification system followed by classification symbols)

IPC:H04B

Documentation searched other than minimum documentation to the extent that such documents are included in the fields searched

Electronic data base consulted during the international search (name of data base and, where practicable, search terms used)

CNTXT; VEN; WPABSC; ENTXTC; WPABS; ENTXT; WOTXT; CNKI: 放大器, 放大电路, 放大, 功放, 光电二极管, 光电元件, 光电器件, 光, 电, 转换, 变换, 阻抗, 调制, 调整, 调节, 改变, 匹配, 功率, 最大, 回退, 多尔蒂, 多赫蒂, Doherty, amplifier, PD, photodiode, optical, electric, convert, impedance, modulate, adjust, regulate, match, power, maximum, back off

### C. DOCUMENTS CONSIDERED TO BE RELEVANT

| Category* | Citation of document, with indication, where appropriate, of the relevant passages | Relevant to claim No. |
|---|---|---|
| A | WO 2022041286 A1 (HUAWEI TECHNOLOGIES CO., LTD.) 03 March 2022 (2022-03-03) description, p. 5, line 10 to p. 10, line 5, and figures 1-19 | 1-28 |
| A | US 2010284703 A1 (SUZUKI YASUYUKI) 11 November 2010 (2010-11-11) entire document | 1-28 |
| A | US 2021014801 A1 (VIVO MOBILE COMMUNICATION CO., LTD.) 14 January 2021 (2021-01-14) entire document | 1-28 |
| A | CN 112448677 A (QINGDAO MARINE TECHNOLOGY RESEARCH INSTITUTE, TIANJIN UNIVERSITY) 05 March 2021 (2021-03-05) entire document | 1-28 |

☐ Further documents are listed in the continuation of Box C.      ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **18 July 2023** | **03 August 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

| | INTERNATIONAL SEARCH REPORT | | International application No. |
|---|---|---|---|
| | Information on patent family members | | **PCT/CN2023/091372** |

| Patent document cited in search report | | | Publication date (day/month/year) | Patent family member(s) | | | Publication date (day/month/year) |
|---|---|---|---|---|---|---|---|
| WO | 2022041286 | A1 | 03 March 2022 | None | | | |
| US | 2010284703 | A1 | 11 November 2010 | JP | 5339088 | B2 | 13 November 2013 |
| | | | | WO | 2009069814 | A1 | 04 June 2009 |
| | | | | US | 8483581 | B2 | 09 July 2013 |
| US | 2021014801 | A1 | 14 January 2021 | EP | 3780398 | A1 | 17 February 2021 |
| | | | | WO | 2019184948 | A1 | 03 October 2019 |
| CN | 112448677 | A | 05 March 2021 | None | | | |

Form PCT/ISA/210 (patent family annex) (July 2022)

**REFERENCES CITED IN THE DESCRIPTION**

**Patent documents cited in the description**

- CN 202210577560